(19) **Europäisches Patentamt / European Patent Office / Office européen des brevets**

(11) **EP 3 062 442 B1**

(12) # EUROPEAN PATENT SPECIFICATION

(45) Date of publication and mention
of the grant of the patent:
**16.01.2019 Bulletin 2019/03**

(51) Int Cl.:
**H03H 17/02** [(2006.01)]  **H03H 11/12** [(2006.01)]

(21) Application number: **15156984.5**

(22) Date of filing: **27.02.2015**

(54) **HYBRID RECURSIVE ACTIVE FILTERING WITH ADAPTIVE TRANSFER FUNCTION SHAPING CAPABILITY**

HYBRIDE REKURSIVE AKTIVFILTERUNG MIT ADAPTIVER ÜBERTRAGUNGSFUNKTIONSFORMFÄHIGKEIT

FILTRAGE ACTIF RÉCURSIF HYBRIDE AVEC CAPACITÉ DE MISE EN FORME ADAPTATIVE DE FONCTION DE TRANSFERT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**31.08.2016 Bulletin 2016/35**

(73) Proprietor: **Friedrich-Alexander-Universität Erlangen-Nürnberg**
**91054 Erlangen (DE)**

(72) Inventors:
• **Felgentreff, Tilman**
  **83607 Holzkirchen (DE)**
• **Gottardo, Giuseppe**
  **91058 Erlangen (DE)**
• **Fischer, Georg**
  **90425 Nürnberg (DE)**

(74) Representative: **Patentship**
**Patentanwaltsgesellschaft mbH**
**Elsenheimerstraße 65**
**80687 München (DE)**

(56) References cited:
**WO-A1-98/00910**     **US-A1- 2001 005 402**
**US-A1- 2012 314 736**     **US-A1- 2014 280 415**

• **LISITSKIY A P ET AL: "DIGITAL FEEDBACK PARAMETER OPTIMIZATION", TELECOMMUNICATIONS AND RADIO ENGINEERING, SCRIPTA TECHNICA,INC., NEW YORK, NY, US, vol. 41/42, no. 8, 1 August 1987 (1987-08-01), page 80/81, XP000050534, ISSN: 0040-2508**
• **Giuseppe Gottardo ET AL: "Novel Hybrid Recursive Active Filters in RF Transmitter Front-Ends", 2014 German Microwave Conference (GeMIC), 12 March 2014 (2014-03-12), pages 1-4, XP055209965, Aachen, Germany ISBN: 978-3-80-073585-3 Retrieved from the Internet: URL:http://ieeexplore.ieee.org/ielx7/67750 98/6775099/06775156.pdf?tp=&arnumber=67751 56&isnumber=6775099 [retrieved on 2015-08-27]**
• **DELMOND M ET AL: "HIGH-ORDER MONOLITHIC ACTIVE RECURSIVE FILTER BASED UPON MULTICELLULAR APPROACH", 1996 IEEE MTT-S INTERNATIONAL MICROWAVE SYMPOSIUM DIGEST. SAN FRANCISCO, JUNE 17 - 21, 1996; [IEEE MTT-S INTERNATIONAL MICROWAVE SYMPOSIUM DIGEST], NEW YORK, IEEE, UI, 17 June 1996 (1996-06-17), pages 623-626, XP000731947, ISBN: 978-0-7803-3247-8**
• **JANGHEON KIM ET AL: "Analysis of Adaptive Digital Feedback Linearization Techniques", IEEE TRANSACTIONS ON CIRCUITS AND SYSTEMS I: REGULAR PAPERS, IEEE, US, vol. 56, no. 2, 1 February 2010 (2010-02-01), pages 345-354, XP011294591, ISSN: 1549-8328**

**Description**

**Field**

The present invention relates to hybrid recursive active filtering with adaptive transfer function shaping capability. More specifically, the present invention relates to a hybrid recursive active filter, a method of operating the same, and a computer program product for carrying out the method of operating the same.

**Background**

In order to comply with recent mobile communication standards (such as e.g. GSM, LTE, LTE-A and WCDMA), radio-frequency units like RF front-ends of communication apparatuses (such as e.g. base stations, base transceiver stations, and access nodes) do have to fulfill stringent requirements. Among others, such requirements relate to specifications in terms of out-of-band noise, spurious emissions and wideband noise as well as interference between the transmit and receive bands.

To this end, duplex filters are used in the RF front-end of a communication apparatus, which are often designed as high-order air cavity band-pass filters having a high quality factor. However, such cavity filters are expensive and have big dimensions, and moreover they are designed to work at an accurately tuned and fixed frequency band only.

Accordingly, it is desirable to replace such cavity filters with more compact and cost-effective solutions, which are preferably also frequency-adaptive.

Hybrid recursive active filters are representing a solution to the aforementioned problem. Such filters comprise an analog power amplifier in a forward path and digital signal processing means in a feedback loop. So, analog parts of conventional filters are replaced by digital signal processing means using functional (software-based) algorithms. Thereby, they allow an appropriate quality factor. The article by G. Gottardo et al. "Novel Hybrid Recursive Active Filters in RF Transmitter Front-Ends" published during the 2014 German Microwave Conference (GeMIC) in March 2014 describes such a known filter. Moreover, patent documents US2001005402 and US2012314736 and the article by A. P. Lisitskiy et al. "Digital Feedback Parameter Optimization" published in Telecommunications and Radio Engineering, vol. 41/42, no. 8, in August 1987, disclose a power amplifier with a feedback loop including a digital signal processing unit to apply a predistortion to the input of the power amplifier and thus compensate for its non-linearity.

However, while being somewhat frequency-adaptive, known hybrid recursive active filters cannot provide for sufficient adaptability for ensuring appropriate transfer function shaping in view of the aforementioned requirements. Further, due to the digital feedback loop, such hybrid recursive active filters are subject to stability problems.

Accordingly, there is still a demand for a technique for hybrid recursive active filtering with adaptability, ensuring appropriate transfer function shaping in view of the aforementioned requirements as well as stable operability.

**Summary**

Various exemplifying embodiments of the present invention aim at addressing at least part of the above issues and/or problems and drawbacks.

Various aspects of exemplifying embodiments of the present invention are set out in the appended claims.

According to an example aspect of the present invention, there is provided a hybrid recursive active filter, comprising analog power amplifier means in a forward path for amplifying an amplifier input signal to generate an output signal, and first digital signal processing means in a feedback loop for generating a feedback signal on the basis of the output signal and for combining the feedback signal with the input signal to generate the amplifier input signal, wherein the first digital signal processing means in the feedback loop comprises a plurality of digital feedback paths, each digital feedback path being configured to process the output signal with a path-specific attenuation and a path-specific delay, and combining means for combining processed signals from the plurality of digital feedback paths to generate the feedback signal, setting means for setting parameters of the first digital signal processing means, the parameters including the path-specific attenuation and/or the path-specific delay of one or more of the plurality of digital feedback paths, open-loop characterization means for detecting current open-loop characteristics of the filter, wherein the setting means is configured to set the parameters of the first digital signal processing means on the basis of the detected current open-loop characteristics of the filter, an analog-to-digital conversion circuitry at the input side of the first digital signal processing means, and a digital-to-analog conversion circuitry at the output side of the first digital signal processing means, wherein the open-loop characteristics of the filter comprise an open-loop transfer function for analog elements of the filter, the analog elements including the power amplifier means, the analog-to-digital conversion circuitry and the digital-to-analog conversion circuitry.

According to an example aspect of the present invention, there is provided a communication apparatus, comprising a radio-frequency unit comprising a hybrid recursive active filter according to the aforementioned example aspect of the present invention.

According to an example aspect of the present invention, there is provided a method of operating a hybrid recursive active filter, comprising analog power amplifier means in a forward path and first digital signal processing means in a feedback loop, the method comprising amplifying an amplifier input signal by the analog power amplifier means in the forward path to generate an output signal, generating a feedback signal on the basis of the output signal and combining the feedback signal with the input signal to generate the amplifier input signal by the first digital signal processing means in the feedback loop, wherein the feedback signal is generated in the first digital signal processing means by processing the output signal in a plurality of digital feedback paths, each digital feedback path exhibiting a path-specific attenuation and a path-specific delay, and combining processed signals from the plurality of digital feedback paths, setting parameters of the first digital signal processing means, the parameters including the path-specific attenuation and/or the path-specific delay of one or more of the plurality of digital feedback paths, and detecting current open-loop characteristics of the filter, wherein the parameters of the first digital signal processing means are set on the basis of the detected current open-loop characteristics of the filter, and wherein the open-loop characteristics of the filter comprise an open-loop transfer function for analog elements of the filter, the analog elements including the power amplifier means, analog-to-digital conversion circuitry in the filter and digital-to-analog conversion circuitry in the filter.

According to an example aspect of the present invention, there is provided a computer program product comprising computer-executable computer program code which, when the program code is executed (or run) on a computer or the program is run on a computer (e.g. a computer of an apparatus according to any one of the aforementioned apparatus-related example aspects of the present invention), is configured to cause the computer to carry out the method according to the aforementioned method-related example aspect of the present invention.

The computer program product may comprise or may be embodied as a (tangible/non-transitory) computer-readable (storage) medium or the like, on which the computer-executable computer program code is stored, and/or the program is directly loadable into an internal memory of the computer or a processor thereof.

Further developments and/or modifications of the aforementioned example aspects of the present invention are set out in the following.

By way of exemplifying embodiments of the present invention, a technique for hybrid recursive active filtering with adaptability, ensuring appropriate transfer function shaping in view of the aforementioned requirements as well as stable operability, can be enabled/realized.

Brief description of the drawings

In the following, the present invention will be described in greater detail by way of non-limiting examples with reference to the accompanying drawings, in which

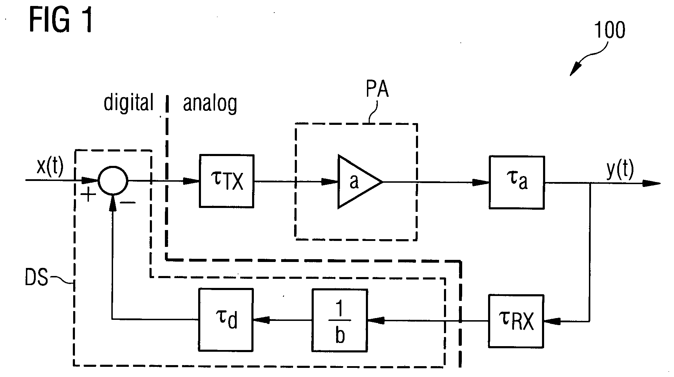

Figure 1 shows a schematic block diagram of a structure of a hybrid recursive active filter with single-feedback digital signal processing according to an example for explaining the present invention,

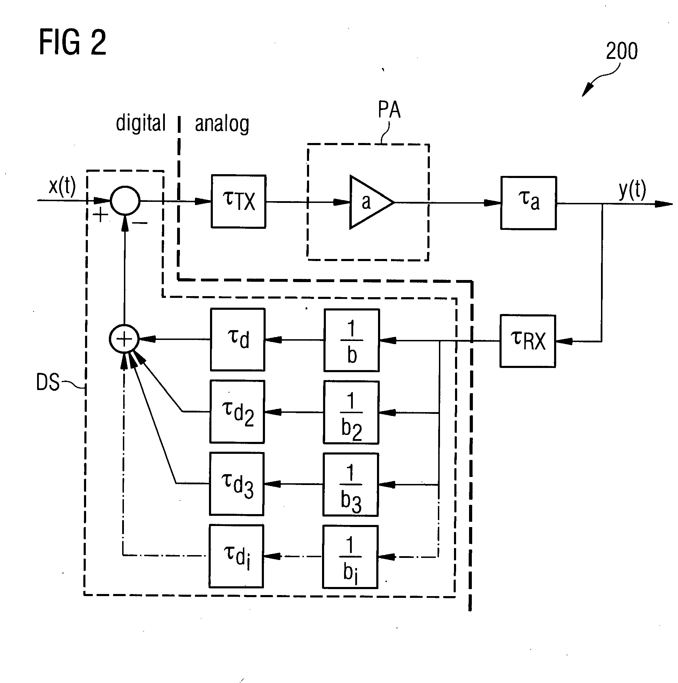

Figure 2 shows a schematic block diagram of a structure of a hybrid recursive active filter with multi-feedback digital signal processing according to an example for explaining the present invention,

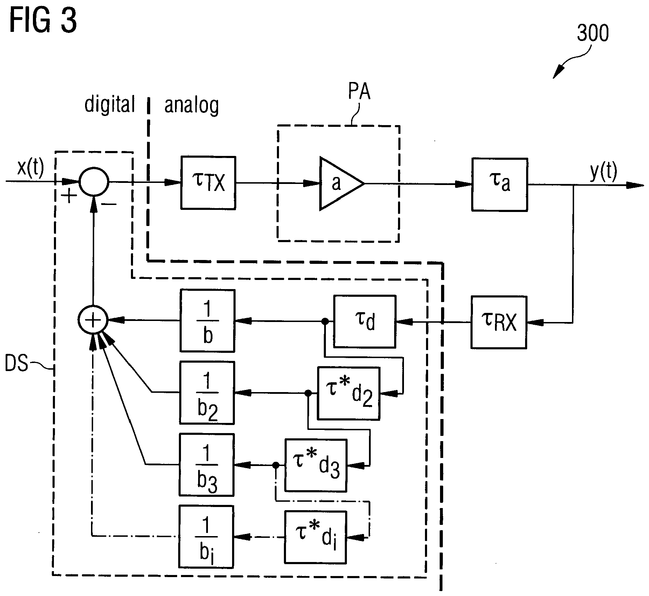

Figure 3 shows a schematic block diagram of a structure of a hybrid recursive active filter with multi-feedback digital signal processing according to an example for explaining the present invention,

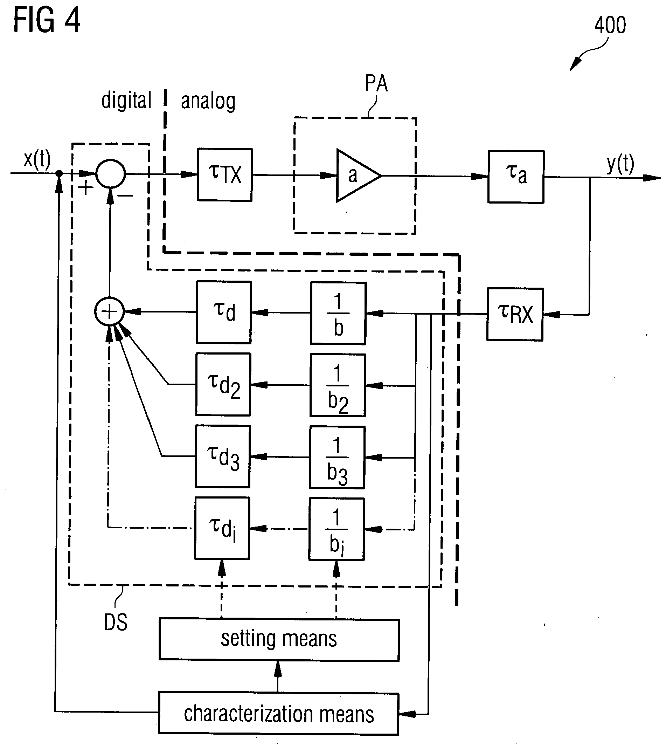

Figure 4 shows a schematic block diagram of a structure of a hybrid recursive active filter with multi-feedback digital signal processing according to exemplifying embodiments of the present invention,

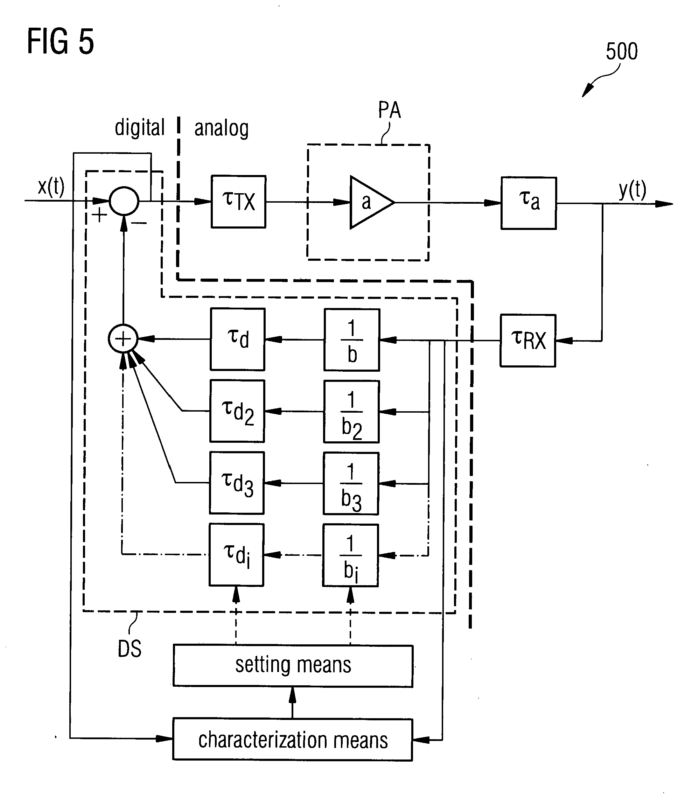

Figure 5 shows a schematic block diagram of a structure of a hybrid recursive active filter with multi-feedback digital signal processing according to exemplifying embodiments of the present invention,

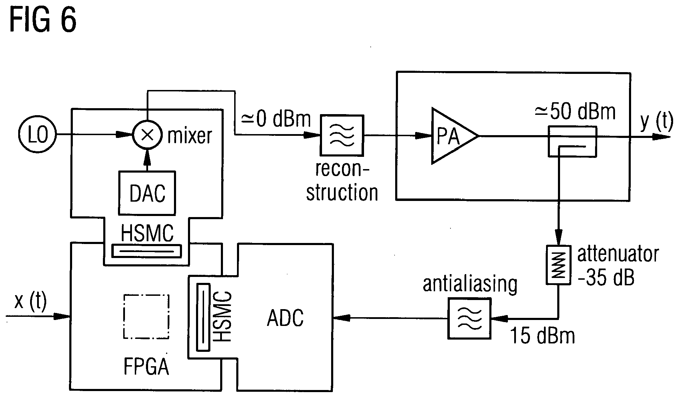

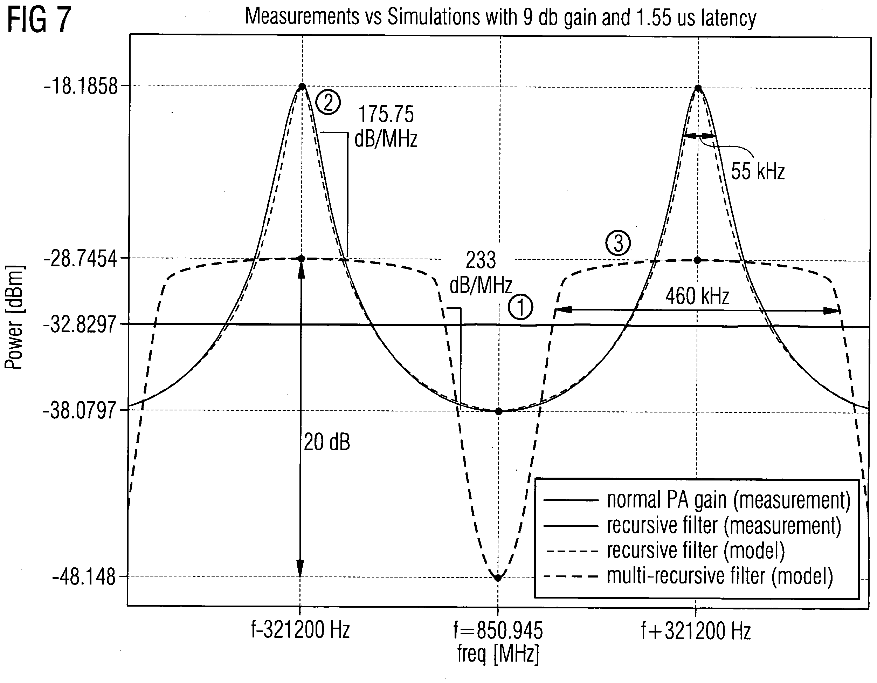

Figure 6 shows a schematic block diagram of a FPGA implementation example of a hybrid recursive active filter with multi-feedback digital signal processing according to an example for explaining the present invention, Figure 7 shows a graph of magnitudes of overall transfer functions for a comparison of a hybrid recursive active filter with multi-feedback digital signal processing, with 20 digital feedback paths and total loop delay 1.55 $\mu$s, and a hybrid recursive active filter with single-feedback digital signal processing,

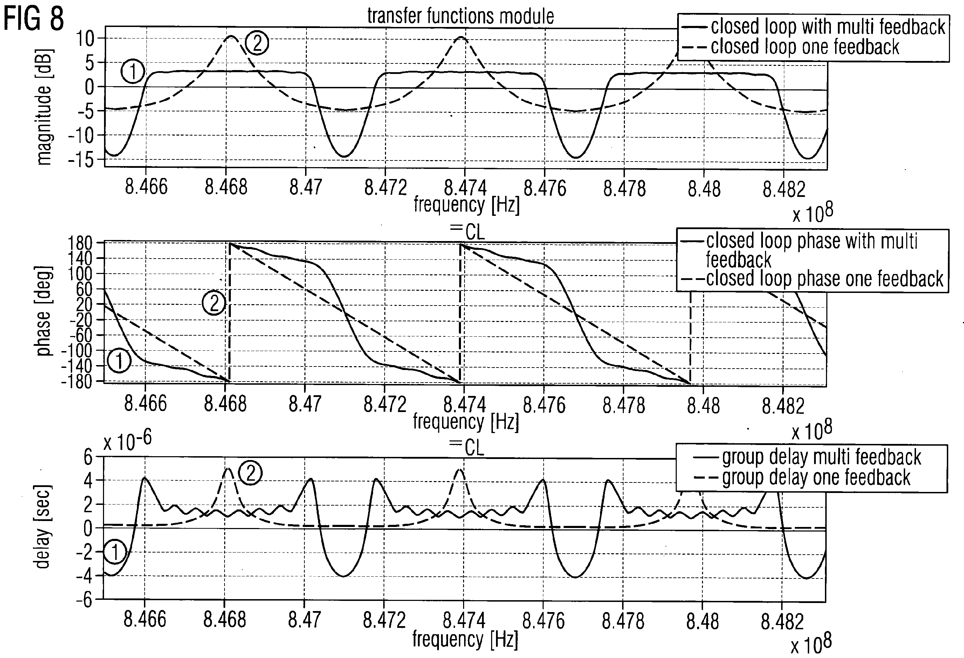

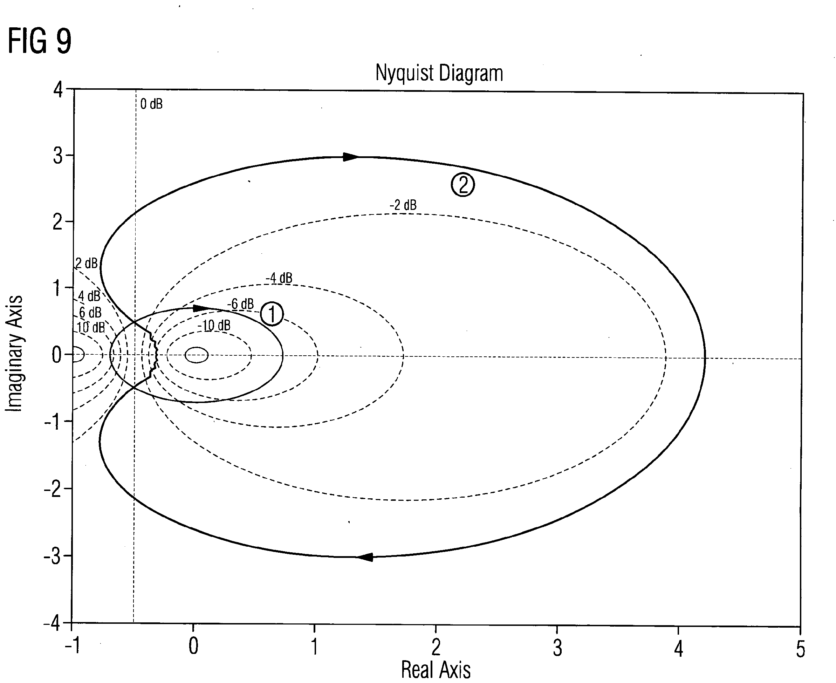

Figures 8 and 9 show graphs of simulation results for a comparison of a hybrid recursive active filter with multi-feedback digital signal processing, with 10 digital feedback paths, total loop delay 1.7 $\mu$s and K=-0.8, and a hybrid recursive active filter with single-feedback digital signal processing,

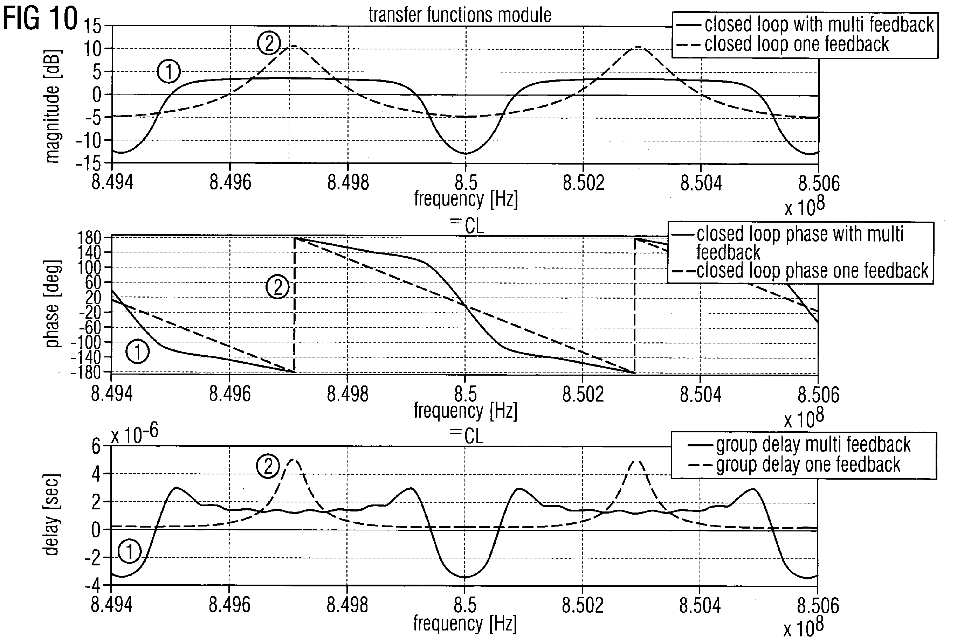

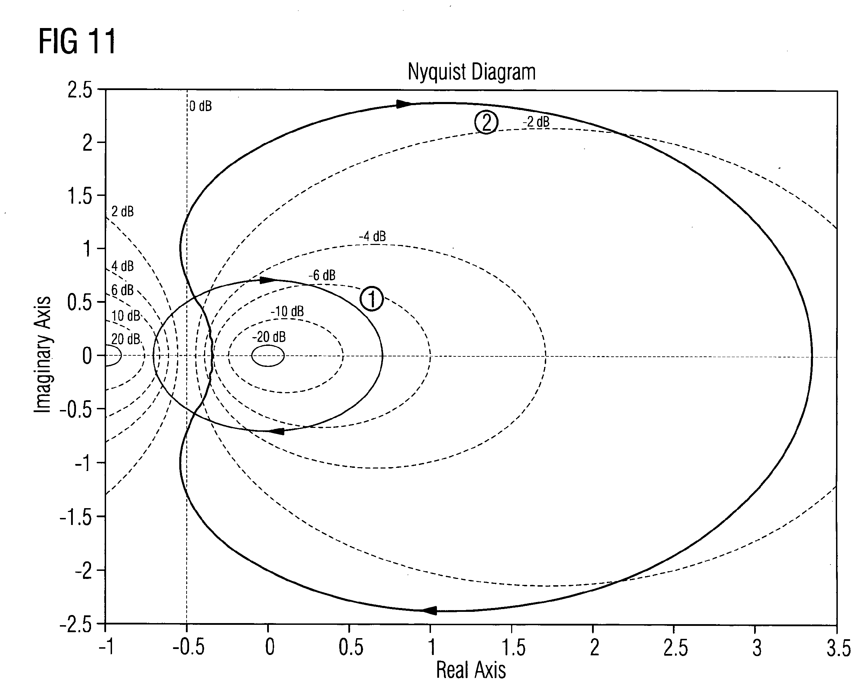

Figures 10 and 11 show graphs of simulation results for a comparison of a hybrid recursive active filter with multi-feedback digital signal processing, with 10 digital feedback paths, total loop delay 1.7 $\mu$s and K=0, and a hybrid recursive active filter with single-feedback digital signal processing,

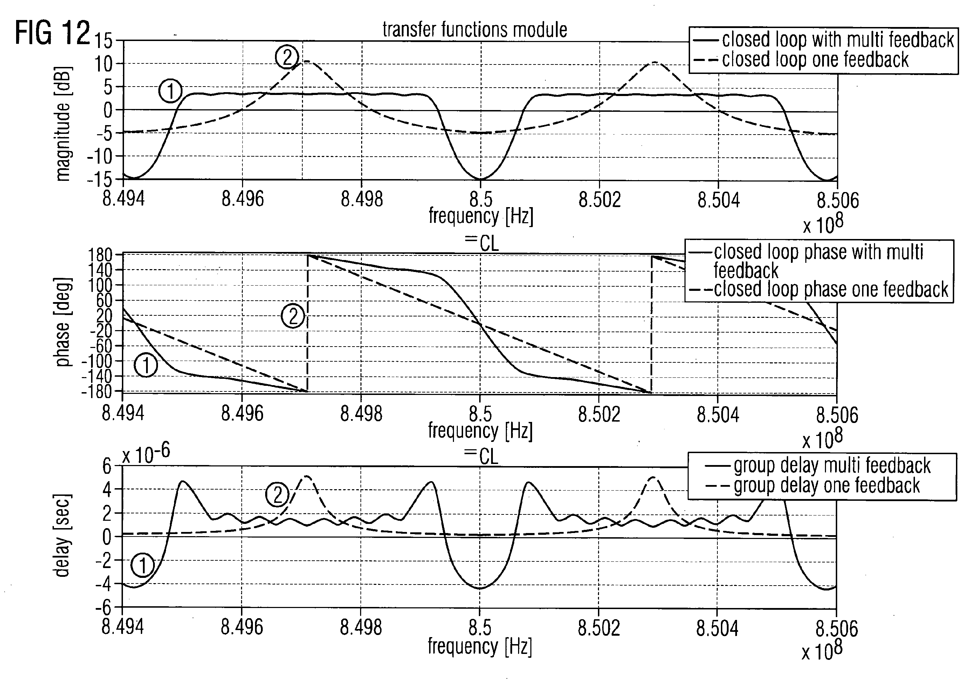

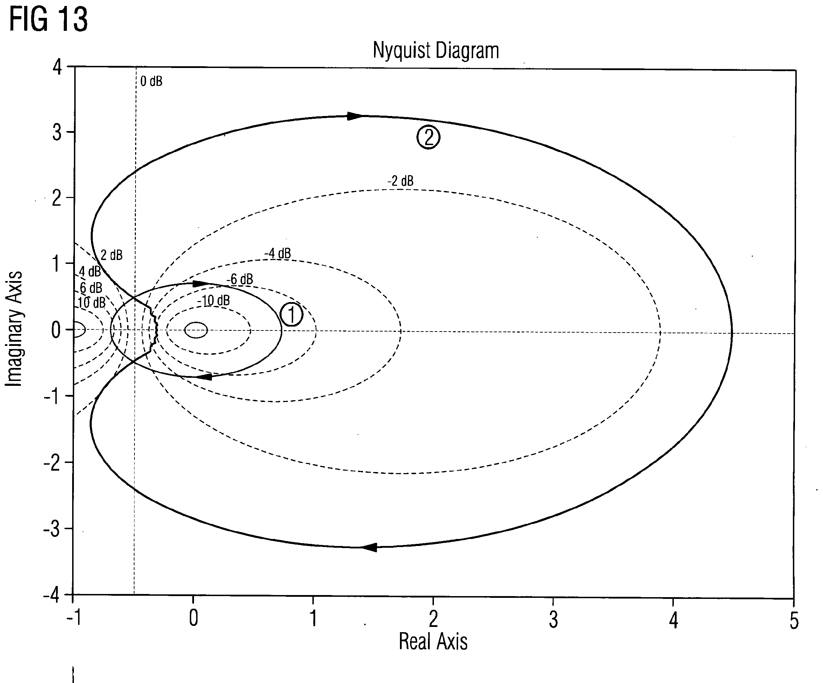

Figures 12 and 13 show graphs of simulation results for a comparison of a hybrid recursive active filter with multi-feedback digital signal processing, with 10 digital feedback paths, total loop delay 1.7 $\mu$s and K=-1, and a hybrid recursive active filter with single-feedback digital signal processing,

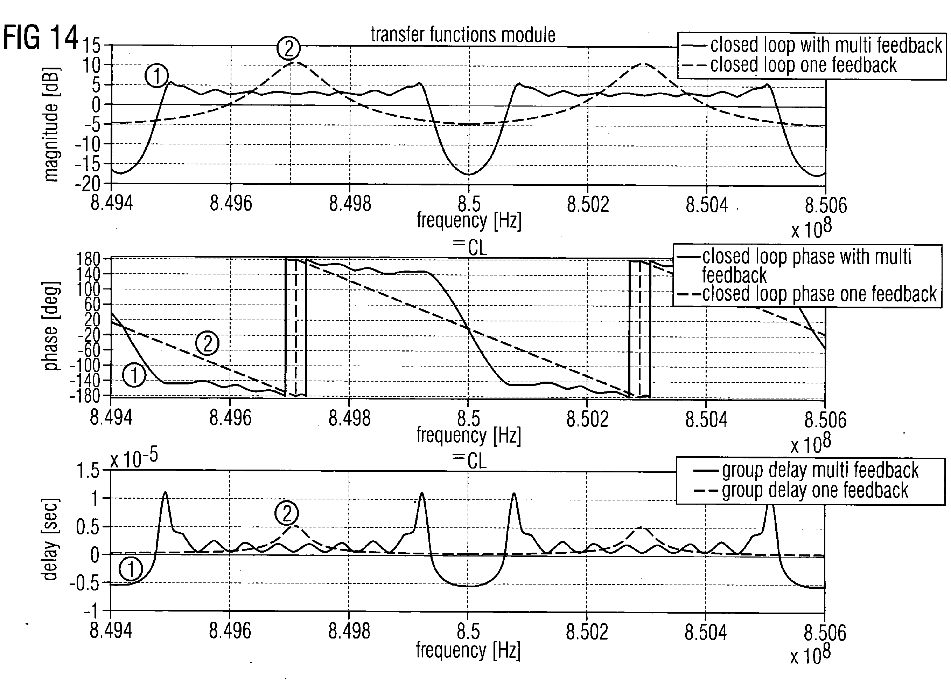

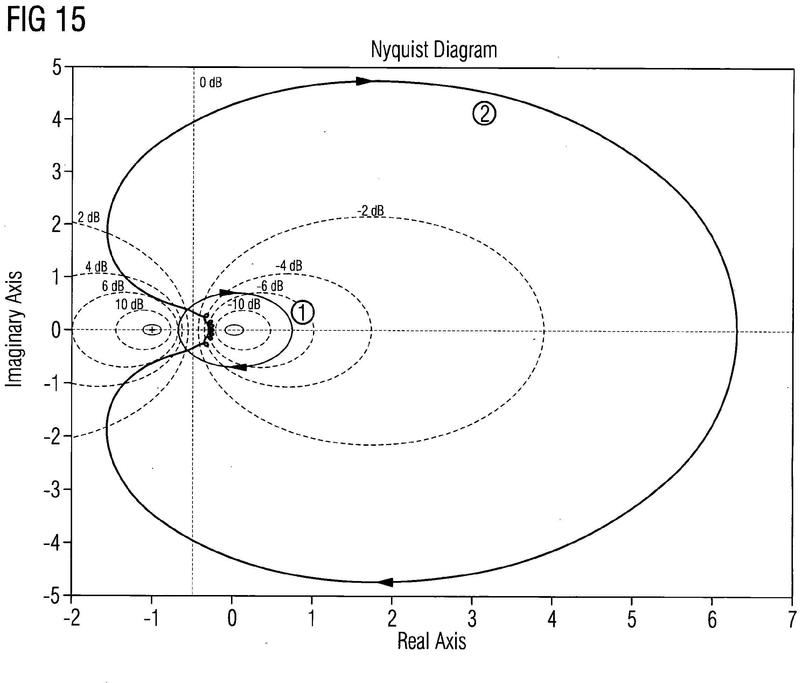

Figures 14 and 15 show graphs of simulation results for a comparison of a hybrid recursive active filter with multi-feedback digital signal processing, with 10 digital feedback paths, total loop delay 1.7 $\mu$s and K=-2, and a hybrid recursive active filter with single-feedback digital signal processing,

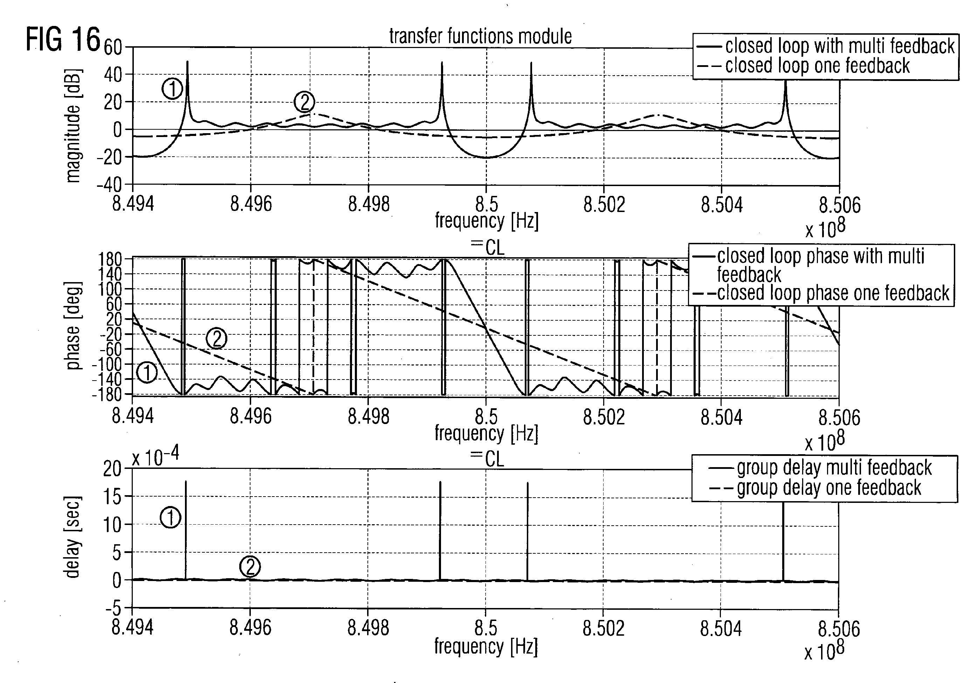

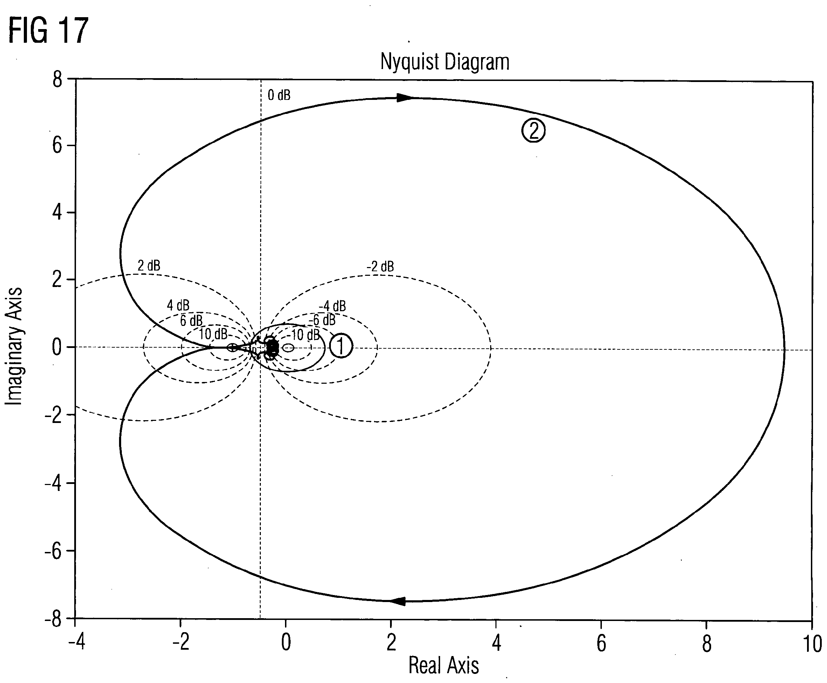

Figures 16 and 17 show graphs of simulation results for a comparison of a hybrid recursive active filter with multi-feedback digital signal processing, with 10 digital feedback paths, total loop delay 1.7 $\mu$s and K=-3, and a hybrid recursive active filter with single-feedback digital signal processing,

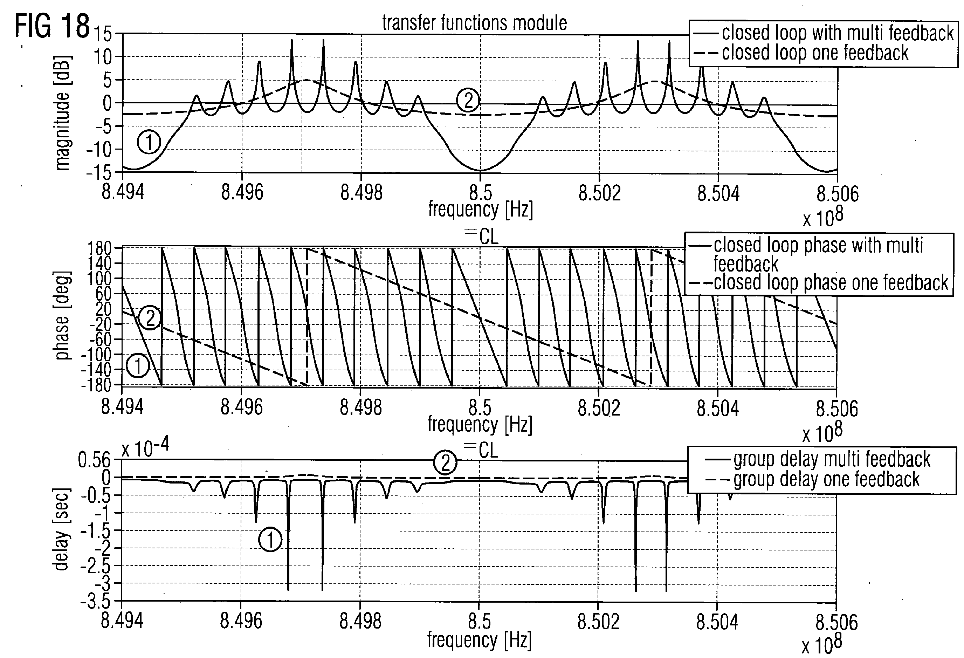

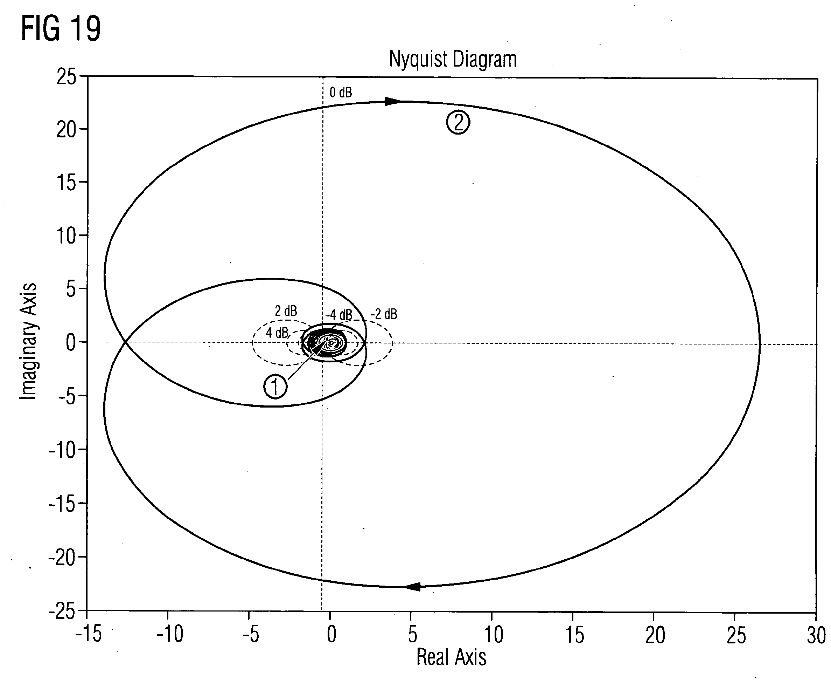

Figures 18 and 19 show graphs of simulation results for a comparison of a hybrid recursive active filter with multi-feedback digital signal processing, with 10 digital feedback paths, total loop delay 1.7 $\mu$s and K=-5, and a hybrid recursive active filter with single-feedback digital signal processing,

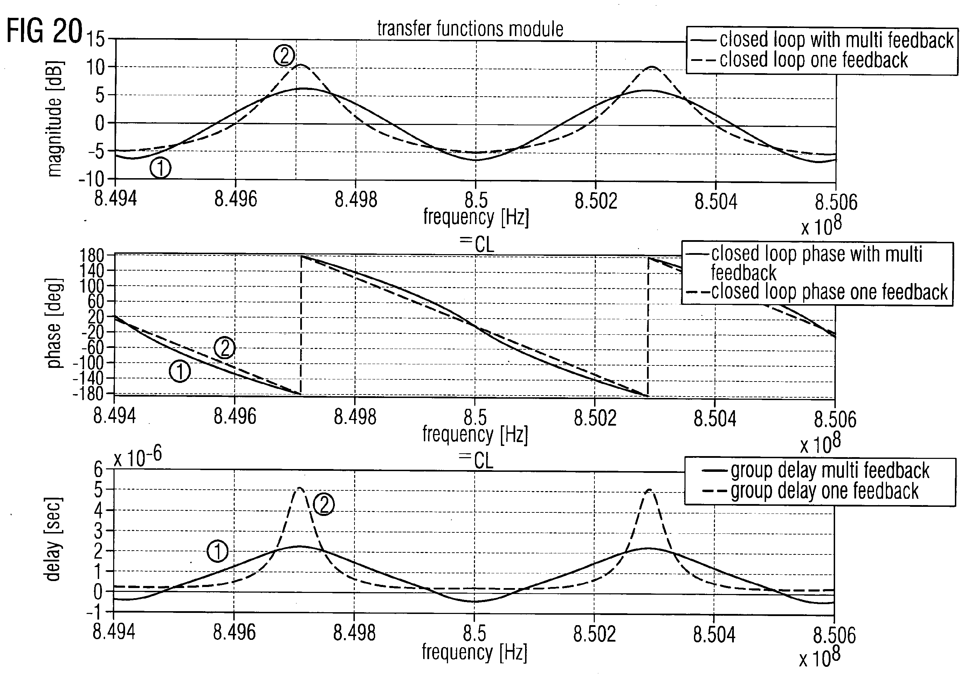

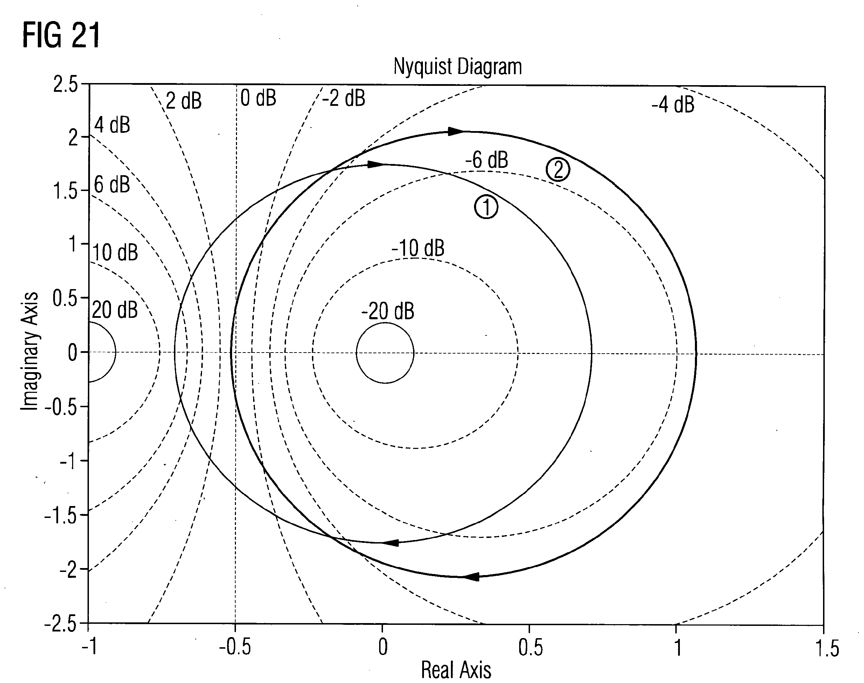

Figures 20 and 21 show graphs of simulation results for a comparison of a hybrid recursive active filter with multi-feedback digital signal processing, with 10 digital feedback paths, total loop delay 1.7 $\mu$s and K=9, and a hybrid recursive active filter with single-feedback digital signal processing,

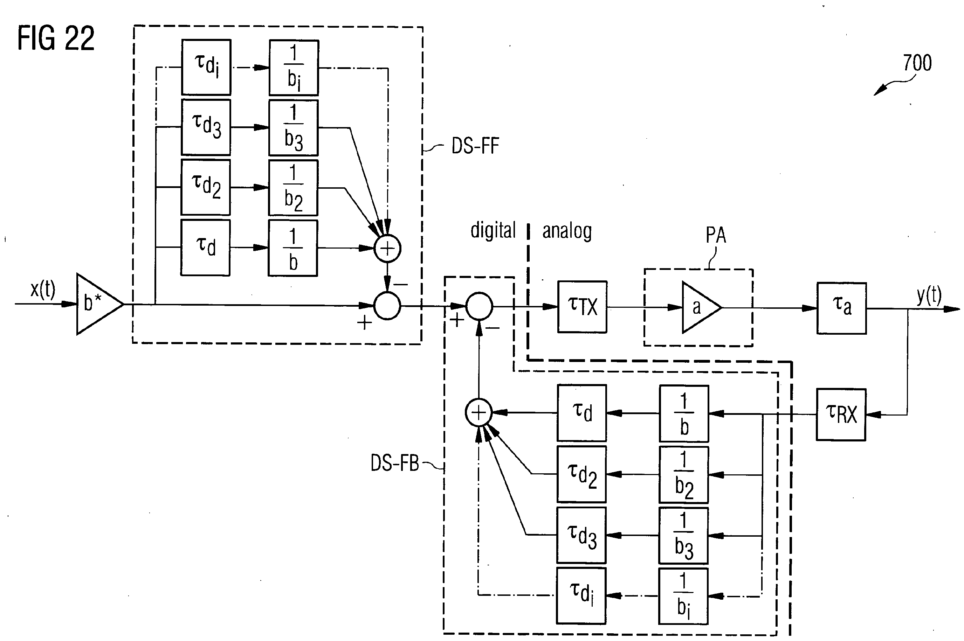

Figure 22 shows a schematic block diagram of a structure of a hybrid recursive active filter with multi-feedback digital signal processing and multi-feedforward digital signal processing according to exemplifying embodiments of the present invention, and

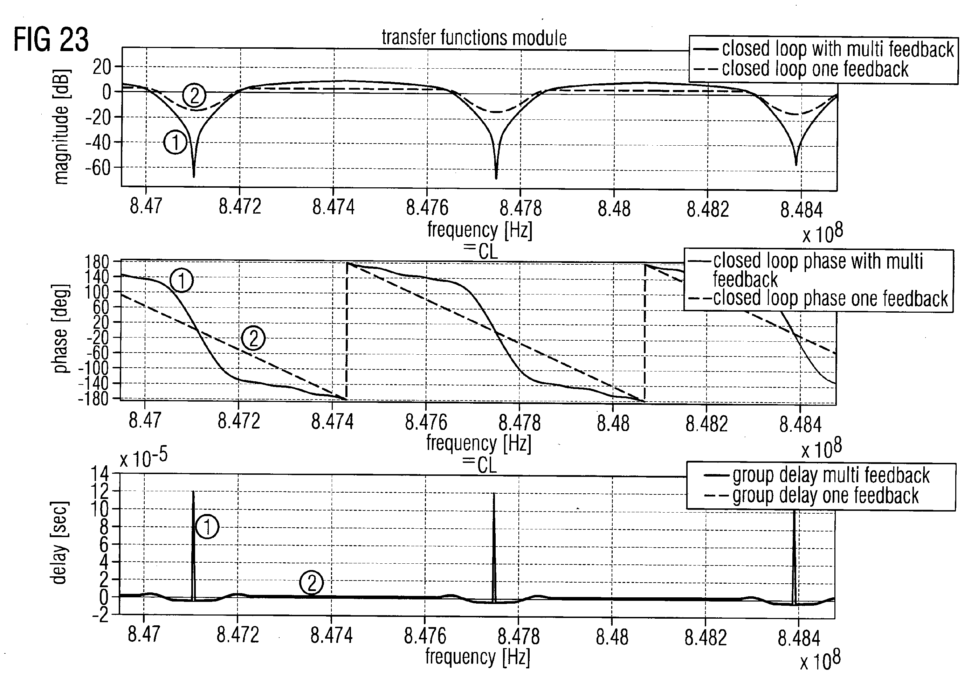

Figure 23 shows graphs of simulation results for a comparison of a hybrid recursive active filter with multi-feedback digital signal processing and feedforward digital signal processing and a hybrid recursive active filter with multi-feedback digital signal processing and without feedforward digital signal processing.

Detailed description

The present invention is described herein with reference to particular non-limiting examples and to what are presently considered to be conceivable embodiments of the present invention. A person skilled in the art will appreciate that the present invention is by no means limited to these examples and embodiments, and may be more broadly applied.

It is to be noted that the following description of the present invention and its embodiments mainly refers to explanations being used as non-limiting examples for exemplifying purposes. As such, the description of exemplifying embodiments given herein specifically refers to terminology which is related thereto. Such terminology is only used in the context of the presented non-limiting examples, and does naturally not limit the present invention in any way. Rather, any other structures, elements, modules, functionalities, etc. may also be utilized as long as complying with what is described herein and/or exemplifying embodiments described herein are applicable to it.

Hereinafter, various exemplifying embodiments and implementations of the present invention and its aspects are described using several variants and/or alternatives. It is generally noted that, according to certain needs and constraints, all of the described variants and/or alternatives may be provided alone or in any conceivable combination (also including combinations of individual features of the various variants and/or alternatives). In this description, the words "comprising" and "including" should be understood as not limiting the described exemplifying embodiments and implementations to consist of only those features that have been mentioned, and such exemplifying embodiments and implementations may also contain features, structures, elements, modules, functionalities etc. that have not been specifically mentioned.

In the drawings, it is noted that lines/arrows interconnecting individual blocks or entities are generally meant to illustrate an operational coupling there-between, which may be a physical and/or logical coupling, which on the one hand is implementation-independent (e.g. wired or wireless) and on the other hand may also comprise an arbitrary number of intermediary functional blocks or entities not shown.

According to exemplifying embodiments of the present invention, in general terms, there is provided a technique for hybrid recursive active filtering with adaptability, ensuring appropriate transfer function shaping in view of the aforementioned requirements as well as stable operability.

Figure 1 shows a schematic block diagram of a structure of a hybrid recursive active filter with single-feedback digital signal processing according to an example for explaining the present invention.

As shown in Figure 1, the present hybrid recursive active filter (100) comprises analog power amplifier means (PA) in a forward path for amplifying an input signal (x(t)) to generate an output signal (y(t)) and digital signaling processing means (DS) in a feedback loop for applying a feedback signal on the basis of the output signal (i.e. digital baseband feedback) on the input signal. In the digital signaling processing means (DS), the output signal is processed by a single feedback path exhibiting a path-specific attenuation ($1/b$) and a path-specific delay ($\tau_d$), and the processed signal is mixed with the input signal (by way of subtraction). Further, a represents a gain introduced the forward path by the power amplifier means, $\tau_{TX}$ represents a delay introduced in the forward path by analog circuitry (such as DAC circuitry (not shown) at the boundary between the digital and the analog domains), $\tau_a$ represents a delay introduced in the forward path by the power amplifier means, and $\tau_{RX}$ represents a delay introduced in the feedback loop by analog circuitry (such as ADC circuitry (not shown) at the boundary between the analog and the digital domains).

Figure 2 shows a schematic block diagram of a structure of a hybrid recursive active filter with multi-feedback digital signal processing according to an example for explaining the present invention. As shown in Figure 2, the present hybrid recursive active filter (200) comprises analog power amplifier means (PA) in a forward path for amplifying an input signal (x(t)) to generate an output signal (y(t)) and digital signaling processing means (DS) in a feedback loop for applying a feedback signal on the basis of the output signal (i.e. digital baseband feedback) on the input signal. In the digital signaling processing means (DS), as a non-limiting example, there are four digital feedback paths for processing the output signal, respectively. Each digital feedback path is configured to process the output signal with a path-specific attenuation ($1/b, 1/b_2, 1/b_3, 1/b_i$) and a path-specific delay ($\tau_d, \tau_{d2}, \tau_{d3}, \tau_{di}$), and combining means for combining processed signals from the four digital feedback paths (by way of addition) to generate the feedback signal. Then, the feedback signal is mixed with the input signal (by way of subtraction). Further, like in Figure 1, a represents a gain introduced in the forward path by the power amplifier means, $\tau_{TX}$ represents a delay introduced in the forward path by analog circuitry (such as DAC circuitry (not shown) at the boundary between the digital and the analog domains), $\tau_a$ represents a delay introduced in the forward path by the power amplifier means, and $\tau_{RX}$ represents a delay introduced in the feedback loop by analog circuitry (such as ADC circuitry (not shown) at the boundary between the analog and the digital domains).

As evident from Figure 2, a multi-feedback digital structure is used to recombine the feedback-digitalized signal with different latencies and attenuations. Thereby, a hybrid negative (multi-path) feedback is established in the recursive active filter. As shown below, an enlarged bandwidth of the pass-band peaks and/or an increased slope/steepness of the transfer function can thus be attained, for example. Using such hybrid solution (i.e. digital feedback applying on an analog power amplifier), a number of real-time adaptive digital designs are possible in order to obtain the desired transfer function over frequency at the filter/transmitter output.

It is to be noted that, while Figure 2 exemplifies a hybrid recursive active filter with four digital feedback paths for illustrative purposes only, any number of a plurality of digital feedback paths, i.e. two or more digital feedback paths, is feasible in a hybrid recursive active filter with multi-feedback digital signal processing. Namely, as indicated by a general branch denoted with i in Figure 2, the thus depicted concept can be applied with an arbitrary number of digital feedback paths, and is thus to be understood with a general meaning in the broadest sense. As non-limiting examples thereof, implementations with 10 and 20 branches are discussed below for illustrative purposes only.

Also, it is to be noted that the order/sequence of attenuation and delay elements in each feedback path represents an illustrative example only, while the order/sequence thereof may also be reverse, or the attenuation and delay properties may be integrated within a single element.

In the filter of Figure 2, the path-specific attenuation (1/b) in an $i$-th feedback path, with $i \geq 2$, can be set (as a non-limiting example) by

$$\frac{1}{b_i} = \frac{1}{b_{i-1}} - K - (i - 2),$$

wherein K is a configurable parameter.

As will be evident from the below description and comparison of simulation results (in Figures 8 to 21), K is a parameter that changes the steepness of the transition bandwidth (between the pass band and the stop band regions) and - at the same time - controls the distance of the working point of the filter from the point of instability. The value of parameter K can be changed in order to control the operation of the filter, either manually or automatically e.g. depending on current open-loop characteristics of the filter (as described in connection with Figures 4 and 5 below).

As shown in Figure 2, the path-specific attenuation in each feedback path can be provided by an attenuation element having a corresponding attenuation.

In the filter of Figure 2, the path-specific delay ($\tau_d$) in an $i$-th feedback path, with $i \geq 2$, can be set (as a non-limiting example) by

$$\tau_{d_i} = i \cdot \tau - (\tau_{TX} + \tau_a + \tau_{RX}),$$

wherein $\tau$ is a constant depending on system technology and/or architecture of the filter, e.g. 1.7 $\mu$s.

As shown in Figure 2, the path-specific delay in each feedback path is provided by a delay element having a corresponding delay.

As a numerical example, the present hybrid recursive active filter (200) can be realized with the following parameters:

$a$ = 9 dB
$1/b$ = - 10.8 dB (including coupler and attenuation)
$1/b_2$ = - 10 dB (including coupler and attenuation)
$1/b_3$ = - 10.2 dB (including coupler and attenuation)

$$1/b_i \;\; = \;\; 1/b_{i-1} - K - (i-2)$$

....... (e.g. $1/b_{19}$ = - 149.4 dB (including coupler and attenuation))
$\tau_d$ = 1 clock tick ($\cong$ 0)

$$\tau_{TX} + \tau_a + \tau_{RX} + \tau_d = 1.55 \; \mu s$$

In such design example (upon which the curve denoted by ③ in Figure 7 is based), a hybrid recursive active filter with a wide dynamic range and selectivity, a broad passband, and an increased steepness/slope can be realized.

Figure 3 shows a schematic block diagram of a second example structure of a hybrid recursive active filter with multi-feedback digital signal processing according to an example for explaining the present invention.

As shown in Figure 3, the structure of the present hybrid recursive active filter (300) is similar to that of the hybrid recursive active filter of Figure 2 (with four digital feedback paths being illustrated as a non-limiting example, one of which is indicated as a general branch denoted with $i$). Accordingly, the description of similar points is omitted, while reference is made to the above description of Figure 2. The present structure basically differs in the provision of path-specific delay in digital feedback paths with a rank of 2 or more.

In the filter of Figure 3, while the path-specific delay ($\tau_d$) in an $i$-th feedback path, with $i \geq 2$, can be set as indicated above for the filter of Figure 2, the path-specific delay in each feedback path is not provided by a delay element having a corresponding delay. Rather, the path-specific delay in each feedback path is provided by the sum of all delay elements in feedback paths with a lower rank and a delay element (in the subject feedback path) having a delay $\tau_d{}^*$ set by

$$\tau_{di}{}^* \;= \; \tau.$$

This is based on the following considerations, as explained below.

The value of $\tau$ is dependent on system technology and/or architecture of the filter, e.g. 1.7 $\mu$s. In view of the above equation for the path-specific delay, as described for the filter of Figure 2, it holds that:

$$\tau_{d_1} + (\tau_{TX} + \tau_a + \tau_{RX}) = \tau$$

$$\tau_{d_i} = i \cdot \tau - (\tau_{TX} + \tau_a + \tau_{RX}) \quad for \;\; i = 2 \ldots n$$

The problem of this expression is that the path-specific delay for each feedback path of a rank of 2 or more can only be accurately calculated when the values of the delays $\tau_{TX}$, $\tau_a$ and $\tau_{RX}$ are accurately known. As such knowledge might not be reliably available, it is difficult to properly construct the feedback paths. To avoid this problem, the delays can also be expressed in another way.

From the initial expression, it can be followed that:

$$\tau_{d_{i+1}} > \tau_{d_i} \quad for \;\; i = 2 \ldots n$$

6

Moreover, the following holds:

$$\tau_{d_{i+1}} - \tau_{d_i} = (i+1) \cdot \tau - (\tau_{TX} + \tau_a + \tau_{RX}) - [i \cdot \tau - (\tau_{TX} + \tau_a + \tau_{RX})] = \tau$$

for

$$i = 2 \ldots n$$

This means that each feedback path adds just $\tau_d$ every time with respect to the previous feedback path, and it means that the delays of the individual delay elements used in the structure of Figure 3 can (as a non-limiting example) be:

$$\tau_{d_i}^* = \tau = 1.7 \, \mu s \quad \text{for} \quad i = 2 \ldots n$$

So, the delay element in the feedback path with rank 2 ($\tau_{d2}{}^*$) has the value $\tau$, and the overall delay in this feedback path is $\tau_d + \tau_{d2}{}^*$. Further, the delay element in the feedback path with rank 3 ($\tau_{d3}{}^*$) also has the value $\tau$, and the overall delay in this feedback path is $\tau_d + \tau_{d2}{}^* + \tau_{d3}{}^*$, and so forth.

As compared with the structure of Figure 2, the structure of Figure 3 is beneficial in terms of hardware resource usage, e.g. in a FPGA implementation of the digital signal processing means. Namely, the path-specific delays of all feedback paths can thereby by provided using less delay blocks and resources e.g. of a FPGA. For example, considering the case of $\tau = 1.7 \, \mu s$ and a sampling frequency of 120 MHz, the structure of Figure 2 would require a shift register with a total length of 9000 shifts, while the structure of Figure 2 could get along with a shift register with a total length of about 2100 shifts, i.e. less than 25% compared to the other structure. Further, the calculation of uncertain parameters can be avoided, thus saving processing/computation power.

Although not illustrated herein, it is to be noted that similar considerations and results, as described above for the delay, equally apply for the attenuation as well. In brief, instead of providing the path-specific attenuation in each feedback path by an attenuation element having a corresponding attenuation, the path-specific attenuation in each feedback path by the sum of all attenuation elements in feedback paths with a lower rank and an attenuation element (in the subject feedback path).

The filter of any one of Figure 2 and 3 may be operated in/with a (operating method) comprising amplifying an input signal by the analog power amplifier means in the forward path to generate an output signal, and applying a feedback signal on the basis of the output signal on the input signal by the digital signaling processing means in the feedback loop, wherein the feedback signal is generated in the digital signaling processing means by processing the output signal in a plurality of digital feedback paths, each digital feedback path exhibiting a path-specific attenuation and a path-specific delay, and combining processed signals from the plurality of digital feedback paths.

Figure 4 shows a schematic block diagram of a structure of a hybrid recursive active filter with multi-feedback digital signal processing according to exemplifying embodiments of the present invention. Like in Figures 2 and 3, four digital feedback paths are illustrated as a non-limiting example, one of which is indicated as a general branch denoted with i.

As shown in Figure 4, the present hybrid recursive active filter (400) comprises setting means and open-loop characterization means. The setting means is for setting parameters of the digital signal processing means (i.e. "digital parameters"), including the path-specific attenuation and/or the path-specific delay of one or more of the plurality of digital feedback paths (as indicated by dashed arrows). The open-loop characterization means is configured for detecting current open-loop characteristics of the filter, and the setting means is configured to set the parameters of the digital signal processing means on the basis of the thus detected current open-loop characteristics of the filter.

Thereby, an automatic setting of parameters of the digital signal processing means (or, stated in other words, a (real-time) configuration or calibration of the filter) can be enabled. Namely, any parameters of the digital signal processing means can be appropriately set, such as e.g. one or more of $1/b_i$, $\tau_{di}$ or $\tau_{di}{}^*$, and K.

Herein, the open-loop characteristics of the filter comprise an open-loop gain or, more specifically, an open-loop transfer function for the power amplifier means, analog-to-digital conversion circuitry and digital-to-analog conversion circuitry in the filter.

As indicated in Figure 4, the open-loop characterization means is configured to inject, as a calibration input signal, a pilot tone at a modulation carrier position of the output signal (at the input side of the forward path), to measure an open-loop gain for the injected pilot tone (at the input side of the digital signal processing means), and to determine the open-loop characteristics of the filter on the basis of the measured open-loop gain for the injected pilot tone. That is to say, the pilot tone is hidden in the actual signal. For example, in the case of OFDM modulation, a pilot signal can be injected at the carrier position (i.e. in the middle of the OFDM signal) in order to measure the gain variations of the analog components and to correct them, choosing a safe point of operation with a high selectivity gain

By way of such approach, the open-loop transfer function can be obtained at the frequency of the pilot tone. Further, the characterization can be obtained as near as possible to the edge of stability of the filter operation (i.e. a point where good selectivity and steepness of the bandpass filter can be reached).

Figure 5 shows a schematic block diagram of a structure of a hybrid recursive active filter with multi-feedback digital signal processing according to exemplifying embodiments of the present invention.

As shown in Figure 5, the structure of the present hybrid recursive active filter (500) is similar to that of the hybrid recursive active filter of Figure 4 (with four digital feedback paths being illustrated as a non-limiting example, one of which is indicated as a general branch denoted with i). Accordingly, the description of similar points is omitted, while reference is made to the above description of Figure 4. The present structure basically differs in the function of the open-loop characterization means.

As indicated in Figure 5, the open-loop characterization means is configured to capture an inbound digital signal after analog-to-digital conversion at the input side of the digital signal processing means, to capture an outbound digital signal before digital-to-analog conversion at the output side of the digital signal processing means, to compare the captured inbound digital signal with the captured outbound digital signal, and to determine the open-loop characteristics of the filter on the basis of the comparison.

By way of such approach, the open-loop transfer function can be obtained as the spectrum at the ADC output divided by the spectrum at the DAC input. Thus, due to the strict digital nature of the comparison, the open-loop transfer function can be obtained over a wide bandwidth (in contrast to the above pilot tone approach, where the characterization can be obtained at the single frequency of the pilot tone only).

Both of the open-loop characterization means of Figures 4 and 5 enable a real-time characterization of the open-loop behavior of the filter. By way of such characterization, analog drift and/or fluctuation effects of the analog elements of the filter, i.e. the power amplifier means, analog-to-digital conversion circuitry and digital-to-analog conversion circuitry in the filter, can be observed in real-time. Thereby, performance and selectivity can be improved.

Such characterization can be accomplished during the actual operation of the filter, e.g. the base station comprising the filter, without (remarkably) affecting its operation. That is to say, the open-loop behavior of the filter can be characterized *in-situ*, i.e. during regular operation, without having to stop an actual operation. Thereby, such characterization can be performed and considered regularly or even (quasi) permanently, thus improving the operability of the filter, without requiring an out-of-service time or a specific (calibration/measurement) mode switching. Moreover, the characterization can be obtained in an actual/large signal regime rather than a small signal regime which would be case in a specific measurement or calibration mode.

It is to be noted, while Figures 4 and 5 show respective implementations comprising both setting means and open-loop characterization means for illustrative purposes only, it is also feasible that a hybrid recursive active filter with multi-feedback digital signal processing comprises only the setting means. Thereby, a manual setting of parameters of the digital signal processing means can be enabled. Also, it is to be noted that any one of the setting means and the open-loop characterization means can be realized in an apparatus such as a communication apparatus comprising the filter, but do not need to be realized in the filter as such, as long as the can accomplish the above-described functions, respectively.

By way of a corresponding parameter setting in the digital feedback loop (i.e. a corresponding configuration or calibration of the filter), instability can be avoided in that chaotic oscillations massive disturbances, etc. occurring in the instability region can be compensated for.

It is to be noted that, although not illustrated, the above-described principles of digital parameter setting and/or open-loop characterization are equally applicable to a hybrid recursive active filter with single-feedback digital signal processing, such as that of Figure 1.

According to exemplifying embodiments of the present invention, the filter of any one of Figure 4 and 5 may be operated in/with a (operating) method comprising setting parameters of the digital signal processing means, also comprising detecting current open-loop characteristics of the filter, wherein the parameters of the digital signal processing means are set on the basis of the detected current open-loop characteristics of the filter. For open-loop characterization, the (operating) method may comprise injecting, as a calibration input signal, a pilot tone at a modulation carrier position of the output signal, measuring an open-loop gain for the injected pilot tone, and determining the open-loop characteristics of the filter on the basis of the measured open-loop gain for the injected pilot tone. Alternatively, for open-loop characterization, the (operating) method may comprise capturing an inbound digital signal after analog-to-digital conversion at the input side of the digital signal processing means, capturing an outbound digital signal before digital-to-analog conversion at the output side of the digital signal processing means, comparing the captured inbound digital signal with the captured outbound digital signal, and determining the open-loop characteristics of the filter on the basis of the comparison.

Figure 6 shows a schematic block diagram of a FPGA implementation example of a hybrid recursive active filter with multi-feedback digital signal processing.

As shown in Figure 6, the present hybrid recursive active filter (600) comprises a digital signal processing means in FPGA implementation. In the example implementation of Figure 6, a High Speed Mezzanine Card (HSMC) is used as an adapter interface between ADC and DAC circuits and the FPGA (motherboard), while this is only an illustrative example.

The output signal produced by the PA may have around 50 dBm power. It is collected with a coupler an attenuated by 35 dB. Thus, the signal having 15 dBm power is sampled, e.g. by a 12-bit 3.6 GSample/s A/D converter and is fed to the FPGA for digital signal processing. The signal is reconstructed with a fast 16-bit D/A converter running up to 1.5 GSample/s and an I/Q modulator to reach the RF frequency at a power of 0 dBm.

With such high-speed A/D converter, it is possible to avoid the use of a mixer for the analog down conversion in order to decrease the noise figure commonly added in the feedback by analog mixing. Thus, the use of digital down conversion allows to reach frequency agility and a feedback loop with configurable bandwidth.

It is to be noted that, while Figure 6 exemplifies a hybrid recursive active filter in a FPGA implementation for illustrative purposes only, any other implementation of the digital signal processing means is feasible for a hybrid recursive active filter. For example, the digital signal processing means can be implemented as an ASIC, a DSP, or the like.

The filter of any one of Figure 2 to 6 can be included in a radio-frequency unit such as a RF front-end. Further, the filter of any one of Figure 2 to 6 and/or such radio-frequency unit can be included in a communication apparatus. Such communication apparatus may be compliant with any mobile communication system/standard, such as e.g. GSM, LTE, LTE-A and WCDMA). For example, such communication apparatus may be a base station, a base transceiver station, an access node, or the like.

In the following, performance of various types/implementations is briefly discussed with reference to various graphs.

Firstly, an example with real parameters for multi-feedback is presented, together with the difference between single- and multi-feedback configurations.

Figure 7 shows a graph of magnitudes of overall transfer functions for a comparison of a hybrid recursive active filter with multi-feedback digital signal processing, with 20 digital feedback paths (and 1.55 $\mu$s total loop delay), and a hybrid recursive active filter with single-feedback digital signal processing. For the single-feedback case, there are depicted both simulation and measurement results in order to show the reliability of the simulation.

In Figure 7, the curve denoted by ① represents a normal PA gain (as a normalized result of measurement), i.e. a PA gain without a recursive filter structure, the curve denoted by ② represents a gain of a recursive filter (by way of measurement), i.e. a single-feedback filter structure, and the (dashed) curve denoted by ③ represents a gain of a recursive multi-feedback filter structure.

As evident from Figure 7, the transfer function of a normal PA without a recursive filter structure is nearly constant over bandwidth, while the transfer function of a recursive filter structure describes a periodic bandpass filter response.

By way of provision of a multi-feedback structure, a passband filter with flat passband gain and not just repetitive narrowband peaks can be obtained, and very high steepness/slope and attenuation over frequency can be attained. Namely, a broader passband can be achieved. In the illustrated example (with 9dB forward gain and 10.8 dB attenuation in the feedback and 1.55 $\mu$s latency), the passband can be enlarged to about 460 kHz (as compared with about 56 kHz with a single-feedback structure). Hence, the multi-feedback structure can attain more than eight times - 3dB bandwidth of a single-feedback structure with the same selectivity (20 dB in this case). Further, an increased steepness/slope (defined as the ratio of attenuation in dB over frequency, where the attenuation is measured between the cut-off point and the middle point between maximum gain and attenuation of the passband behavior) can be achieved. In the illustrated example, the steepness/slope of the transition bandwidth is 175.75 dB/MHz in the single-feedback case, while the multi-feedback case allows an enhancement of this steepness/slope up to 233 dB/MHz. Still further, a wide dynamic range can be achieved. In the illustrated example, a dynamic range and selectivity of about 20 dB (between maximum gain and minimum attenuation to the normal output) can be realized.

As mentioned above, a (more) appropriate and flexible shaping can be achieved with a suitable number of digital feedback paths (e.g. even more than 20 digital feedback paths). With a larger number of digital feedback paths, not only the bandwidth of the passband can be enhanced, but also the slope/steepness of the transition band, allowing the design of filters with high quality factors. It is to be noted that a filter with less overall (group) delay (e.g. less than 1.55 $\mu$s, as mentioned above) can be used in order to obtain less repetitions over frequency and a larger bandwidth for each resonance peak.

In all of Figures 8 to 21, the curve denoted by ① represents simulation results for a hybrid active recursive filter having a multi-feedback filter structure (with 10 digital feedback paths), while the curve denoted by ② represents simulation results for a conventional hybrid active recursive filter, i.e. a single-feedback filter structure.

The simulations are made for $\tau$ = 1.7 $\mu$s and a = 0dB, the path-specific delay ($\tau_d$) in an $i$-th feedback path, with $i \geq 2$, is set by:

$$\tau_{d_i} = i \cdot \tau - (\tau_{TX} + \tau_a + \tau_{RX}),$$

and the path-specific attenuation (1/b) in an i-th feedback path, with $i \geq 2$, is set by

$$\frac{1}{b_i} = \frac{1}{b_{i-1}} - K - (i - 2).$$

Further, it holds that $\frac{1}{b} = -a - 3dB$ (which is determined by a minimum condition of stability).

Secondly, it is presented how the transfer function changes with the variation of parameter K. Figures 8, 10, 12, 14, 16, 18 and 20 show graphs of a magnitude of the overall transfer function, the phase of the overall transfer function, and the (group) delay of the filter (or transmitter, if implemented in a RF front-end).

Figures 9, 11, 13, 15, 17, 19 and 21 represent Nyquist diagrams in order to look at the stability of the respective filter configurations.

Namely, as mentioned above, hybrid recursive active filters with a digital feedback loop are subject to stability problems. Thus, a stability analysis is expedient for a full understanding of the behavior and limits of possible instability regions in recursive structures so as to ensure feasibility. In the Nyquist diagram, in Cartesian coordinates, the real part of the transfer function is plotted on the horizontal axis, and the imaginary part of the transfer function is plotted on the vertical axis, while the frequency is swept as a parameter, resulting in one plot (point) per frequency.

The Nyquist criterion states that the number of unstable closed-loop poles of the open-loop transfer function is equal to the number of unstable open-loop poles of the open-loop transfer function minus the number of encirclements of the point (-1, j0) (counted positively for a counterclockwise encirclement and negatively for a clockwise encirclement) of the Nyquist plot of the open-loop transfer function. For stability, the number of unstable closed-loop poles has to be zero, i.e. there must be no positive roots.

Figures 8 and 9 show graphs of simulation results for a comparison of a hybrid recursive active filter with multi-feedback digital signal processing, with 10 digital feedback paths (and 1.7 $\mu$s total loop delay) and K=-0.8, and a hybrid recursive active filter with single-feedback digital signal processing,

Figures 10 and 11 show graphs of simulation results for a comparison of a hybrid recursive active filter with multi-feedback digital signal processing, with 10 digital feedback paths (and 1.7 $\mu$s total loop delay) and K=0, and a hybrid recursive active filter with single-feedback digital signal processing,

Figures 12 and 13 show graphs of simulation results for a comparison of a hybrid recursive active filter with multi-feedback digital signal processing, with 10 digital feedback paths (and 1.7 $\mu$s total loop delay) and K=-1, and a hybrid recursive active filter with single-feedback digital signal processing,

Figures 14 and 15 show graphs of simulation results for a comparison of a hybrid recursive active filter with multi-feedback digital signal processing, with 10 digital feedback paths (and 1.7 $\mu$s total loop delay) and K=-2, and a hybrid recursive active filter with single-feedback digital signal processing,

Figures 16 and 17 show graphs of simulation results for a comparison of a hybrid recursive active filter with multi-feedback digital signal processing, with 10 digital feedback paths (and 1.7 $\mu$s total loop delay) and K=-3, and a hybrid recursive active filter with single-feedback digital signal processing,

Figures 18 and 19 show graphs of simulation results for a comparison of a hybrid recursive active filter with multi-feedback digital signal processing, with 10 digital feedback paths (and 1.7 $\mu$s total loop delay) and K=-5, and a hybrid recursive active filter with single-feedback digital signal processing, and

Figures 20 and 21 show graphs of simulation results for a comparison of a hybrid recursive active filter with multi-feedback digital signal processing, with 10 digital feedback paths (and 1.7 $\mu$s total loop delay) and K=9, and a hybrid recursive active filter with single-feedback digital signal processing.

As evident from Figures 8 to 21, the multi-feedback filter structure enables to adaptively control the passband (e.g. in terms of breadth) and the steepness of the filter. For example, in the case of Figure 8, the steepness may reach about 17.4 dB attenuation over 100 kHz (as the difference in dB between maximum gain and minimum attenuation over frequency).

From the Nyquist diagrams, it can be seen that the parameter K shall be greater than -3 in order to ensure stable operation. Namely, the case of K = -3 represents the theoretical limit (see Figure 17), while the case of K = -5 results in instability (see Figure 19). When K is very big, the multi-feedback structure actually reduces to a single-feedback structure (which is equivalent to the application of a huge attenuation in all feedback paths). This is discernable from the case of K = 9 (see Figure 21).

With the above-described examples, it can be seen how the multi-feedback construction allows an enhancement of the performance of the single-feedback construction, e.g. in terms of steepness/slope and passband width. This enhancement is dependent on the number of branches i used for the multi-feedback design and also on the parameter K that controls the distance of the working point from the stability limit.

Still further, multi-feedback construction according to (exemplifying embodiments of) the present invention allows to reject noise added by the analog power amplifier due the hybrid negative (multi-path) feedback. It can be shown that the noise introduced by the components in the forward path (mainly by the analog power amplifier) is reduced by an amount corresponding to the gain/attenuation in the (overall) feedback path, i.e. by the hybrid negative (multi-path) feedback. Such reduction may be represented by a division of the forward-path noise by the feedback-path gain/attenuation (in the absolute domain) or subtraction of the feedback-path gain/attenuation from the forward-path noise (in the dB domain).

By way of such feasibility study of stability, the closed-loop system can be controlled so as to obtain the best possible performance. In this regard, it is to be noted that the stability is affected just by the gain in the forward path and the attenuation in the feedback loop (i.e. the attenuation in the individual feedback paths) and not by various delays in the system.

Figure 22 shows a schematic block diagram of a structure of a hybrid recursive active filter with multi-feedback digital signal processing and multi-feedforward digital signal processing according to exemplifying embodiments of the present invention.

As shown in Figure 22, the present hybrid recursive active filter (700) comprises analog power amplifier means (PA) in a forward path for amplifying an input signal to generate an output signal (y(t)) and digital signaling processing means (DS-FB) in a feedback loop for applying a feedback signal on the basis of the output signal (i.e. digital baseband feedback) on the input signal, like in any one of Figures 2 to 5. That is, the principles of any one of Figures 2 to 5 are equally applicable for the present hybrid recursive active filter (700) as well, and thus reference is made to the description thereof for details in this regard.

Further, the present hybrid recursive active filter (700) comprises a digital signaling processing means (DS-FF) in a feedforward loop for applying a feedforward signal on the basis of the input signal (i.e. digital baseband feedforward control) on the input signal. Thus, hybrid negative (multi-path) feedforward control is additionally established in the recursive active filter.

In the digital signaling processing means (DS-FF) in the forward path, as a non-limiting example, there are four digital feedback paths for processing the input signal, respectively. Each digital feedback path is configured to process the input signal with a path-specific attenuation ($1/b$, $1/b_2$, $1/b_3$, $1/b_1$) and a path-specific delay ($\tau_d$, $\tau_{d2}$, $\tau_{d3}$, $\tau_{di}$), and combining means for combining processed signals from the four digital feedforward paths (by way of addition) to generate the feedforward signal. Then, the feedforward signal is mixed with the feedback signal from the digital signaling processing means (DS-FB) in the feedback path (by way of subtraction).

It is to be noted that, while Figure 22 exemplifies a hybrid recursive active filter with four digital feedforward paths for illustrative purposes only, any number of digital feedforward paths, i.e. one, two or more digital feedforward paths, is feasible in a hybrid recursive active filter according to exemplifying embodiments of the present invention. For example, as indicated by a general branch denoted with *i* in Figure 22, the thus depicted concept can be applied with an arbitrary number of digital feedforward paths, and is thus to be understood with a general meaning in the broadest sense.

Further, it is to be noted that, while Figure 22 exemplifies a hybrid recursive active filter in which the configuration of the multi-feedforward loop corresponds to the configuration of the multi-feedback loop (in terms of the number of branches, as well as the denominations (and values) of attenuation and delay elements), this is only an illustration without limiting generality. Specifically, it is to be noted that the feedforward loop can be configured independent from the configuration of the feedback loop (in terms of the number of branches, as well as the denominations (and values) of attenuation and delay elements).

Still further, it is to be noted that the path-specific attenuation in each feedforward path ($1/b$, $1/b_2$, $1/b_3$, $1/b_i$) and/or the path-specific attenuation in each feedforward path ($\tau_d$, $\tau_{d2}$, $\tau_{d3}$, $\tau_{di}$) can be realized and set, as described above for the multi-feedback loop in Figures 2 and 3, and can optionally be controlled, as described above for Figures 4 and 5. Like the DS-FB element, the DS-FF element can also be realized as/in a FPGA-based implementation (in the same or a separate FPGA unit as the DS-FF element), as illustrated in Figure 6.

As with the feedback loop, it is to be noted that the order/sequence of attenuation and delay elements in each feedforward path represents an illustrative example only, while the order/sequence thereof may also be reverse, or the attenuation and delay properties may be integrated within a single element

According to exemplifying embodiments of the present invention, as illustrated in Figure 22, a hybrid CIC (cascaded-integrator-comb) filter structure can be realized. Accordingly, well-known principles of CIC filters can be directly applied to the hybrid recursive active filter and a radio-frequency unit or transmitter including the same.

Figure 23 shows graphs of simulation results for a comparison of a hybrid recursive active filter with multi-feedback digital signal processing and feedforward digital signal processing and a hybrid recursive active filter with multi-feedback digital signal processing and without feedforward digital signal processing.

In all of Figure 23, the curve denoted by ① represents simulation results for a hybrid active recursive filter with 20 feedback paths and 1 feedforward path (as an example of a hybrid CIC filter structure according to Figure 22), and ② represents simulation results for a hybrid recursive active with 20 feedback paths and 0 feedforward paths (as an example of a filter structure according to any one of Figures 2 to 5).

As evident from Figure 23, the transfer function of the hybrid CIC filter structure according to Figure 22 enlarges the suppression bandwidth, i.e. the stopband. Accordingly, such filter structure enables to control the stopband behavior of the recursive active filter (by the digital (multi-) feedforward loop) in addition to the passband behavior of the recursive active filter (which is controlled by the digital (multi-) feedback loop, as explained above).

By virtue of exemplifying embodiments of the present invention, as evident from the above, a technique for hybrid recursive active filtering with adaptability, ensuring appropriate transfer function shaping in view of the aforementioned requirements as well as stable operability, can be enabled/realized. More specifically, frequency-agile and re-/configurable filtering can be attained by way of multiple digital feedback paths. As the parameters of the digital feedback loop can be easily and adaptively set, a software-defined/definable filter can be implemented, thus providing applicability for software-defined/definable or cognitive radio. In the end, a "software defined analogue filter" can be created, which matches the wish for reconfigurability with highly selective analog filters.

The usage of digital feedback acting on an analog power amplifier (or, more generally speaking, an analog transmitter), like an IIR filter, is useful for enabling adaptability, ensuring appropriate transfer function shaping as well as stable operability. Further, it is effective in terms of implementation efforts in SDR architectures. In this regard, a bandpass behavior (with a broader passband and/or a broader stopband) of the transmitted signal at the output of the amplifier is obtained, allowing relaxation of duplexer/cavity filter requirements like edge steepness and isolation, saving cost and size of RF front-ends.

As explained above, a hybrid recursive active filter with multi-feedback makes available, at the output of the filter/transmitter, a desired bandpass behavior, thus omitting the need for expensive duplex/cavity filters placed after the filter/transmitter and before antennas and the receiver, saving size and costs. This can be implemented with common digital hardware already in use e.g. for digital predistortion in common BTS transmitters, and it is frequency agile allowing possible reconfiguration depending on the used communication standard.

In general, it is to be noted that respective functionalities, functional blocks or elements described above can be implemented by any known means, either in hardware and/or software, respectively, if it is only adapted to perform the described functions of the respective parts. The mentioned method steps can be realized in individual functional blocks or by individual devices, or one or more of the method steps can be realized in a single functional block or by a single device.

Generally, any structural means such as a portion or other circuitry of an amplifier may refer to one or more of the following: (a) hardware-only circuit implementations (such as implementations in only analog and/or digital circuitry) and (b) combinations of circuits and software (and/or firmware), such as (as applicable): (i) a combination of processor(s) or (ii) portions of processor(s)/software (including digital signal processor(s)), software, and memory(ies) that work together to cause an apparatus, such as a mobile phone or server, to perform various functions) and (c) circuits, such as a microprocessor(s) or a portion of a microprocessor(s), that require software or firmware for operation, even if the software or firmware is not physically present. Also, it may also cover an implementation of merely a processor (or multiple processors) or portion of a processor and its (or their) accompanying software and/or firmware, any integrated circuit, or the like.

Generally, any procedural step or functionality is suitable to be implemented as software/firmware or by hardware without changing the idea of the present invention. Such software may be software code independent and can be specified using any known or future developed programming language, such as e.g. Java, C++, C, and Assembler, as long as the functionality defined by the method steps is preserved. Such hardware may be hardware type independent and can be implemented using any known or future developed hardware technology or any hybrids of these, such as MOS (Metal Oxide Semiconductor), CMOS (Complementary MOS), BiMOS (Bipolar MOS), BiCMOS (Bipolar CMOS), ECL (Emitter Coupled Logic), TTL (Transistor-Transistor Logic), etc., using for example ASIC (Application Specific IC (Integrated Circuit)) components, FPGA (Field-programmable Gate Arrays) components, CPLD (Complex Programmable Logic Device) components or DSP (Digital Signal Processor) components. A device/apparatus may be represented by a semiconductor chip, a chipset, or a (hardware) module comprising such chip or chipset; this, however, does not exclude the possibility that a functionality of a device/apparatus or module, instead of being hardware implemented, be implemented as software in a (software) module such as a computer program or a computer program product comprising executable software code portions for execution/being run on a processor. A device may be regarded as a device/apparatus or as an assembly of more than one device/apparatus, whether functionally in cooperation with each other or functionally independently of each other but in a same device housing, for example.

Software in the sense of the present description comprises software code as such comprising code means or portions or a computer program or a computer program product for performing the respective functions, as well as software (or a computer program or a computer program product) embodied on a tangible medium such as a computer-readable (storage) medium having stored thereon a respective data structure or code means/portions or embodied in a signal or in a chip, potentially during processing thereof.

Apparatuses and/or means or parts thereof can be implemented as individual devices, but this does not exclude that they may be implemented in a distributed fashion throughout the system, as long as the functionality of the device is preserved. Such and similar principles are to be considered as known to a skilled person.

The present invention also covers any conceivable combination of method steps and operations described above, and any conceivable combination of nodes, apparatuses, modules or elements described above, as long as the above-described concepts of methodology and structural arrangement are applicable.

In view of the above, there is provided a technique of hybrid recursive active filtering with adaptive transfer function shaping capability. Such technique exemplarily comprise a hybrid recursive active filter, comprising analog power amplifier means in a forward path for amplifying an input signal to generate an output signal, and digital signaling processing means in a feedback loop for applying a feedback signal on the basis of the output signal on the input signal, wherein the digital signaling processing means comprises a plurality of digital feedback paths, each digital feedback path being configured to process the output signal with a path-specific attenuation and a path-specific delay, and combining means for combining processed signals from the plurality of digital feedback paths to generate the feedback signal.

Even though the invention is described above with reference to the examples according to the accompanying drawings, it is to be understood that the invention is not restricted thereto. Rather, it is apparent to those skilled in the art that the present invention can be modified in many ways without departing from the scope of the inventive idea as disclosed herein.

List of abbreviations and acronyms

| | |
|---|---|
| ADC | Analog-to-Digital Converter |
| ASIC | Application-Specific Integrated Circuit |
| CIC | Cascaded-Integrator-Comb |
| DAC | Digital-to-Analog Converter |
| DS | Digital Signal Processing (means) |
| DSP | Digital Signal Processor |
| FB | Feedback |
| FF | Feedforward |
| FPGA | Field-Programmable Gate Array |
| GSM | Global System for Mobile Communication |
| HSMC | High Speed Mezzanine Card (by Altera) |
| IIR | Infinite Impulse Response |
| LO | Local Oscillator |
| LTE | Long Term Evolution |
| LTE-A | Long Term Evolution Advanced |
| OFDM | Orthogonal Frequency Division Multiplexing |
| PA | Power Amplifier (means) |
| RF | Radio Frequency |
| SDR | Software Defined Radio |
| WCDMA | Wideband Code Division Multiple Access |

**Claims**

1.  A hybrid recursive active filter (100, 200), comprising
    analog power amplifier means (PA) in a forward path for amplifying an amplifier input signal (x(t)) to generate an output signal (y(t)),
    first digital signal processing means (DS) in a feedback loop for generating a feedback signal on the basis of the output signal and for combining the feedback signal with the input signal to generate the amplifier input signal,
    wherein the first digital signal processing means (DS) in the feedback loop comprises a plurality of digital feedback paths, each digital feedback path being configured to process the output signal with a path-specific attenuation and a path-specific delay, and combining means for combining processed signals from the plurality of digital feedback paths to generate the feedback signal,

setting means for setting parameters of the first digital signaling processing means, the parameters including the path-specific attenuation and/or the path-specific delay of one or more of the plurality of digital feedback paths, and open-loop characterization means for detecting current open-loop characteristics of the filter,

wherein the setting means is configured to set the parameters of the first digital signaling processing means on the basis of the detected current open-loop characteristics of the filter, an analog-to-digital conversion circuitry at the input side of the first digital signal processing means, and

a digital-to-analog conversion circuitry at the output side of the first digital signal processing means, **characterized in that**:

the open-loop characteristics of the filter comprise an open-loop transfer function for analog elements of the filter, the analog elements including the power amplifier means, the analog-to-digital conversion circuitry and the digital-to-analog conversion circuitry.

2. The filter (100, 200) according to claim 1, wherein the path-specific attenuation 1/b in an i-th feedback path, with i ≥ 2, is set by

$$\frac{1}{b_i} = \frac{1}{b_{i-1}} - K - (i-2),$$

wherein K is a configurable parameter.

3. The filter (100, 200) according to claim 2, wherein the path-specific attenuation in each feedback path is provided by an attenuation element having a corresponding attenuation.

4. The filter (100, 200) according to any one of claims 1 to 3, wherein the path-specific delay $\tau_d$ in an i-th feedback path, with i ≥ 2, is set by

$$\tau_{d_i} = i \cdot \tau - (\tau_{TX} + \tau_a + \tau_{RX}),$$

wherein $\tau$ is a constant depending on system technology and/or architecture of the filter, $\tau_{TX}$ is a delay introduced in the forward path by analog circuitry, $\tau_a$ is a delay introduced in the forward path by the power amplifier means, and $\tau_{RX}$ is a delay introduced in the feedback loop by analog circuitry.

5. The filter (100, 200) according to claim 4, wherein the path-specific delay in each feedback path is provided by a delay element having a corresponding delay.

6. The filter (100, 200) according to claim 4, wherein the path-specific delay in each feedback path is provided by the sum of all delay elements in feedback paths with a lower rank and a delay element having a delay $\tau_d^*$ set by

$$\tau_d^* = \tau \ .$$

7. The filter (100, 200) according to any one of claims 1 to 6, wherein the open-loop characterization means is configured to

inject, as a calibration input signal, a pilot tone at a modulation carrier position of the output signal,
measure an open-loop gain of the filter for the injected pilot tone, and determine the open-loop characteristics of the filter on the basis of the measured open-loop gain for the injected pilot tone.

8. The filter (100, 200) according to any one of claims 1 to 6, wherein the open-loop characterization means is configured to

capture an inbound digital signal after analog-to-digital conversion at the input side of the digital signal processing means,
capture an outbound digital signal before digital-to-analog conversion at the output side of the digital signal processing means,
compare the captured inbound digital signal with the captured outbound digital signal, and
determine the open-loop characteristics of the filter on the basis of the comparison.

9. The filter (700) according to any one of claims 1 to 8, further comprising
second digital signal processing means (DS-FF) in a feedforward loop for feedforward filtering the input signal (x(t)), wherein the second digital signal processing means (DS-FF) in the feedforward loop comprises at least one digital feedforward path, each digital feedforward path being configured to process the input signal (x(t)) with a path-specific attenuation and a path-specific delay, and, in case of plural digital feedforward paths, combining means for combining processed signals from the plurality of digital feedforward paths to generate the feedforward filtered input signal.

10. A communication apparatus, comprising
a radio-frequency unit comprising the filter (100, 200) according to any one of claims 1 to 9.

11. A method of operating a hybrid recursive active filter (100, 200), comprising analog power amplifier means (PA) in a forward path, first digital signal processing means in a feedback loop, an analog-to-digital conversion circuitry at the input side of the first digital signal processing means, and a digital-to-analog conversion circuitry at the output side of the first digital signal processing means, the method comprising
amplifying an amplifier input signal by the analog power amplifier means (PA) in the forward path to generate an output signal (y(t)),
generating a feedback signal on the basis of the output signal (y(t)) and combining the feedback signal with the input signal (x(t)) to generate the amplifier input signal by the first digital signaling processing means (DS) in the feedback loop,
wherein the feedback signal is generated in the first digital signal processing means (DS) by processing the output signal (y(t)) in a plurality of digital feedback paths, each digital feedback path exhibiting a path-specific attenuation and a path-specific delay, and combining processed signals from the plurality of digital feedback paths,
setting parameters of the first digital signal processing means, the parameters including the path-specific attenuation and/or the path-specific delay of one or more of the plurality of digital feedback paths, and
detecting current open-loop characteristics of the filter,
wherein the parameters of the first digital signal processing means are set on the basis of the detected current open-loop characteristics of the filter,
**characterized in that**:
the open-loop characteristics of the filter comprise an open-loop transfer function for analog elements of the filter, the analog elements including the power amplifier means, the analog-to-digital conversion circuitry and the digital-to-analog conversion circuitry.

12. A computer program product comprising computer-executable computer program code which, when the computer program code is executed on a computer, is configured to cause the computer to carry out the method according to claim 11.

## Patentansprüche

1. Hybrider rekursiver Aktivfilter (100, 200), der Folgendes umfasst:

analoge Leistungsverstärkungsmittel (PA, power amplifier) in einem Vorwärtszweig zum Verstärken eines Verstärkereingangssignals (x(t)) zum Erzeugen eines Ausgangssignals (y(t)),
ein erstes Digitalsignalverarbeitungsmittel (DS) in einer Rückführschleife zum Erzeugen eines Rückführsignals auf Grundlage des Ausgangssignals und zum Kombinieren des Rückführsignals mit dem Eingangssignal zum Erzeugen des Verstärkereingangssignals,
wobei das erste Digitalsignalverarbeitungsmittel (DS) in der Rückführschleife mehrere digitale Rückführzweige, wobei jeder digitale Rückführzweig dazu ausgelegt ist, das Ausgangssignal mit einer zweigspezifischen Dämpfung und einer zweigspezifischen Verzögerung zu verarbeiten, und Kombiniermittel zum Kombinieren der verarbeiteten Signale aus den mehreren digitalen Rückführzweigen zum Erzeugen des Rückführsignals umfasst,
Einstellmittel zum Einstellen von Parametern des ersten Digitalsignalverarbeitungsmittels, wobei die Parameter die zweigspezifische Dämpfung und/oder die zweigspezifische Verzögerung eines oder mehrerer der mehreren digitalen Rückführzweige umfassen, und
Open-Loop-Charakterisierungsmittel zum Detektieren von aktuellen Open-Loop-Charakteristiken des Filters, wobei die Einstellmittel dazu ausgelegt sind, die Parameter des ersten Digitalsignalverarbeitungsmittels auf Grundlage der detektierten aktuellen Open-Loop-Charakteristiken des Filters einzustellen,
eine Analog-zu-Digital-Umwandlungsschaltungsanordnung an der Eingangsseite des ersten Digitalsignalverarbeitungsmittels, und

eine Digital-zu-Analog-Umwandlungsschaltungsanordnung an der Ausgangsseite des ersten Digitalsignalverarbeitungsmittels,

**dadurch gekennzeichnet, dass**:

die Open-Loop-Charakteristiken des Filters eine Open-Loop-Übergangsfunktion für analoge Elemente des Filters umfassen, wobei die analogen Elemente die Leistungsverstärkermittel, die Analog-zu-Digital-Umwandlungsschaltungsanordnung und die Digital-zu-Analog-Umwandlungsschaltungsanordnung umfassen.

2.  Filter (100, 200) nach Anspruch 1, wobei die zweigspezifische Dämpfung 1/b in einem i-ten Rückführzweig, mit i≥2, festgelegt ist durch

$$\frac{1}{b_i} = \frac{1}{b_{i-1}} - K - (i - 2),$$

wobei K ein auslegbarer Parameter ist.

3.  Filter (100, 200) nach Anspruch 2, wobei die zweigspezifische Dämpfung in jedem Rückführzweig durch ein Dämpfungselement mit einer entsprechenden Dämpfung bereitgestellt wird.

4.  Filter (100, 200) nach einem der Ansprüche 1 bis 3, wobei die zweigspezifische Verzögerung $T_d$ in einem i-ten Rückführzweig, mit i≥2, festgelegt ist durch

$$\tau_{d_i} = i \cdot \tau - (\tau_{TX} + \tau_a + \tau_{RX}),$$

wobei $\tau$ eine Konstante in Abhängigkeit von der Systemtechnologie und/oder Architektur des Filters ist, $\tau_{TX}$ eine durch die Analogschaltungsanordnung in den Vorwärtszweig eingebrachte Verzögerung ist, $\tau_a$ eine durch die Leistungsverstärkungsmittel in den Vorwärtszweig eingebrachte Verzögerung ist und $\tau_{RX}$ eine durch die Analogschaltungsanordnung in die Rückführschleife eingebrachte Verzögerung ist.

5.  Filter (100, 200) nach Anspruch 4, wobei die zweigspezifische Verzögerung in jedem Rückführzweig durch ein Verzögerungselement mit einer entsprechenden Verzögerung bereitgestellt wird.

6.  Filter (100, 200) nach Anspruch 4, wobei die zweigspezifische Verzögerung in jedem Rückführzweig durch die Summe aller Verzögerungselemente in Rückführzweigen mit einem niedrigeren Rang und ein Verzögerungselement

mit einer Verzögerung $\tau_d^*$ bereitgestellt wird, die festgelegt ist durch

$$\tau_d^* = \tau.$$

7.  Filter (100, 200) nach einem der Ansprüche 1 bis 6, wobei die Open-Loop-Charakterisierungsmittel ausgelegt sind zum
    Einspeisen, als ein Kalibrierungseingangssignal, eines Pilottons an einer Modulationsträgerposition des Ausgangssignals,
    Messen einer Open-Loop-Verstärkung des Filters für den eingespeisten Pilotton, und
    Bestimmen der Open-Loop-Charakteristiken des Filters auf Grundlage der gemessenen Open-Loop-Verstärkung für den eingespeisten Pilotton.

8.  Filter (100, 200) nach einem der Ansprüche 1 bis 6, wobei die Open-Loop-Charakterisierungsmittel ausgelegt sind zum
    Erfassen eines eingehenden Digitalsignals nach Analog-zu-Digital-Umwandlung auf der Eingangsseite des Digitalsignalverarbeitungsmittels,
    Erfassen eines ausgehenden Digitalsignals vor Digital-zu-Analog-Umwandlung auf der Ausgangsseite des Digitalsignalverarbeitungsmittels,
    Vergleichen des erfassten eingehenden Digitalsignals mit dem erfassten ausgehenden Digitalsignal, und
    Bestimmen der Open-Loop-Charakteristiken des Filters auf Grundlage des Vergleichs.

9. Filter (700) nach einem der Ansprüche 1 bis 8, der ferner Folgendes umfasst:

ein zweites Digitalsignalverarbeitungsmittel (DS-FF) in einer Vorwärtsschleife zur Vorwärtsfilterung des Eingangssignals (x(t)),
wobei das zweite Digitalsignalverarbeitungsmittel (DS-FF) in der Vorwärtsschleife zumindest einen digitalen Vorwärtszweig, wobei jeder digitale Vorwärtszweig dazu ausgelegt ist, das Eingangssignal (x(t)) mit einer zweigspezifischen Dämpfung und
einer zweigspezifischen Verzögerung zu verarbeiten, und, im Falle von mehreren digitalen Vorwärtszweigen, Kombiniermittel zum Kombinieren von verarbeiteten Signalen aus den mehreren digitalen Vorwärtszweigen zum Erzeugen des gefilterten Vorwärts-Eingangssignals umfasst.

10. Kommunikationseinrichtung, umfassend eine Hochfrequenzeinheit, die den Filter (100, 200) gemäß einem der Ansprüche 1 bis 9 umfasst.

11. Verfahren zum Betreiben eines hybriden rekursiven Aktivfilters (100, 200), umfassend analoge Leistungsverstärkermittel (PA) in einem Vorwärtszweig, ein erstes Digitalsignalverarbeitungsmittel in einer Rückführschleife, eine Analog-zu-Digital-Umwandlungsschaltungsanordnung auf der Eingangsseite des ersten Digitalsignalverarbeitungsmittels und eine Digital-zu-Analog-Umwandlungsschaltungsanordnung auf der Ausgangsseite des ersten Digitalsignalverarbeitungsmittels, wobei das Verfahren Folgendes umfasst:

Verstärken des Verstärkereingangssignals durch die analogen Leistungsverstärkermittel (PA) im Vorwärtszweig zum Erzeugen eines Ausgangssignals (y(t)),
Erzeugen eines Rückführsignals auf Grundlage des Ausgangssignals (y(t)) und Kombinieren des Rückführsignals mit dem Eingangssignal (x(t)) zum Erzeugen des Verstärkereingangssignals durch das erste Digitalsignalverarbeitungsmittel (DS) in der Rückführschleife,
wobei das Rückführsignal im ersten Digitalsignalverarbeitungsmittel (DS) durch Verarbeiten des Ausgangssignals (y(t)) in mehreren digitalen Rückführzweigen, wobei jeder digitale Rückführzweig eine zweigspezifische Dämpfung und eine zweigspezifische Verzögerung aufweist, und Kombinieren der verarbeiteten Signale aus den mehreren digitalen Rückführzweigen erzeugt wird,
Einstellen von Parametern des ersten Digitalsignalverarbeitungsmittels, wobei die Parameter die zweigspezifische Dämpfung und/oder die zweigspezifische Verzögerung eines oder mehrerer der mehreren digitalen Rückführzweige umfassen, und
Detektieren von aktuellen Open-Loop-Charakteristiken des Filters,
wobei die Parameter des ersten Digitalsignalverarbeitungsmittels auf Grundlage der detektierten aktuellen Open-Loop-Charakteristiken des Filters eingestellt werden,
**dadurch gekennzeichnet, dass**:
die Open-Loop-Charakteristiken des Filters eine Open-Loop-Übergangsfunktion für analoge Elemente des Filters umfassen, wobei die analogen Elemente die Leistungsverstärkermittel, die Analog-zu-Digital-Umwandlungsschaltungsanordnung und die Digital-zu-Analog-Umwandlungsschaltungsanordnung umfassen.

12. Computerprogrammprodukt, umfassend computerausführbaren Computerprogrammcode, der, wenn der Computerprogrammcode auf einem Computer ausgeführt wird, dazu ausgelegt ist, den Computer zu veranlassen, das Verfahren nach Anspruch 11 durchzuführen.

## Revendications

1. Filtre actif récursif hybride (100, 200), comprenant
un moyen amplificateur de puissance analogique (PA) dans une chaîne d'action destiné à amplifier un signal d'entrée d'amplificateur (x(t)) pour générer un signal de sortie (y(t)),
un premier moyen de traitement du signal numérique (DS) dans une boucle de réaction destiné à générer un signal de réaction sur la base du signal de sortie et à combiner le signal de réaction avec le signal d'entrée pour générer le signal d'entrée d'amplificateur,
le premier moyen de traitement du signal numérique (DS) dans la boucle de réaction comprenant une pluralité de chaînes de réaction numériques, chaque chaîne de réaction numérique étant configurée pour traiter le signal de sortie avec une atténuation spécifique de la chaîne et un retard spécifique de la chaîne, et un moyen de combinaison destiné à combiner les signaux traités issus de la pluralité de chaînes de réaction numériques pour générer le signal de réaction,

un moyen de réglage destiné à régler des paramètres du premier moyen de traitement du signal numérique, les paramètres comportant l'atténuation spécifique de la chaîne et/ou le retard spécifique de la chaîne d'une ou plusieurs de la pluralité de chaînes de réaction numériques, et

un moyen de caractérisation en boucle ouverte destiné à détecter des caractéristiques de courant en boucle ouverte du filtre,

le moyen de réglage étant configuré pour régler les paramètres du premier moyen de traitement du signal numérique sur la base des caractéristiques de courant en boucle ouverte détectées du filtre,

un circuit de conversion analogique-numérique du côté entrée du premier moyen de traitement du signal numérique, et

un circuit de conversion numérique-analogique du côté sortie du premier moyen de traitement du signal numérique, **caractérisé en ce que** :

les caractéristiques en boucle ouverte du filtre comprennent une fonction de transfert en boucle ouverte pour éléments analogiques du filtre, les éléments analogiques comportant le moyen amplificateur de puissance, le circuit de conversion analogique-numérique et le circuit de conversion numérique-analogique.

2. Filtre (100, 200) selon la revendication 1, dans lequel l'atténuation spécifique de la chaîne $1/b$ dans une $i^{\text{ème}}$ chaîne de réaction, avec $i \geq 2$, est définie par

$$\frac{1}{b_i} = \frac{1}{b_{i-1}} - K - (i - 2),$$

où K est un paramètre configurable.

3. Filtre (100, 200) selon la revendication 2, dans lequel l'atténuation spécifique de la chaîne dans chaque chaîne de réaction est fournie par un élément d'atténuation ayant une atténuation correspondante.

4. Filtre (100, 200) selon l'une quelconque des revendications 1 à 3, dans lequel le retard spécifique de la chaîne $\tau_d$ dans une $i^{\text{ème}}$ chaîne de réaction, avec $i \geq 2$, est défini par

$$\tau_{d_i} = i \cdot \tau - (\tau_{TX} + \tau_a + \tau_{RX}),$$

où $\tau$ est une constante dépendant de la technologie du système et/ou de l'architecture du filtre, $\tau_{TX}$ est un retard introduit dans la chaîne d'action par le circuit analogique, $\tau_a$ est un retard introduit dans la chaîne d'action par le moyen amplificateur de puissance, et $\tau_{RX}$ est un retard introduit dans la boucle de réaction par le circuit analogique.

5. Filtre (100, 200) selon la revendication 4, dans lequel le retard spécifique de la chaîne dans chaque chaîne de réaction est fourni par un élément à retard ayant un retard correspondant.

6. Filtre (100, 200) selon la revendication 4, dans lequel le retard spécifique de la chaîne dans chaque chaîne de réaction est fourni par la somme de tous les éléments à retard dans les chaînes de réaction avec un rang inférieur et un élément à retard ayant un retard $\tau_d^*$ défini par

$$\tau_d^* = \tau.$$

7. Filtre (100, 200) selon l'une quelconque des revendications 1 à 6, dans lequel le moyen de caractérisation en boucle ouverte est configuré pour

injecter, comme signal d'entrée d'étalonnage, une tonalité pilote à une position de porteuse de modulation du signal de sortie,

mesurer un gain en boucle ouverte du filtre pour la tonalité pilote injectée, et

déterminer les caractéristiques en boucle ouverte du filtre sur la base du gain en boucle ouverte mesuré pour la tonalité pilote injectée.

8. Filtre (100, 200) selon l'une quelconque des revendications 1 à 6, dans lequel le moyen de caractérisation en boucle ouverte est configuré pour

capturer un signal numérique entrant après la conversion analogique-numérique du côté entrée du moyen de traitement du signal numérique,

capturer un signal numérique sortant avant la conversion numérique-analogique du côté sortie du moyen de traitement du signal numérique,

comparer le signal numérique entrant capturé avec le signal numérique sortant capturé, et

déterminer les caractéristiques en boucle ouverte du filtre sur la base de la comparaison.

9. Filtre (700) selon l'une quelconque des revendications 1 à 8, comprenant en outre

un deuxième moyen de traitement du signal numérique (DS-FF) dans une boucle d'action prédictive destiné au filtrage prédictif du signal d'entrée (x(t)),

le deuxième moyen de traitement du signal numérique (DS-FF) dans la boucle d'action prédictive comprenant au moins une chaîne d'action prédictive numérique, chaque chaîne d'action prédictive numérique étant configurée pour traiter le signal d'entrée (x(t)) avec une atténuation spécifique de la chaîne et un retard spécifique de la chaîne et, dans le cas de plusieurs chaînes d'action prédictive numériques, un moyen de combinaison destiné à combiner les signaux traités issus de la pluralité de chaînes d'action prédictive numérique pour générer le signal d'entrée soumis au filtrage prédictif.

10. Appareil de communication, comprenant

une unité radiofréquence comprenant le filtre (100, 200) selon l'une quelconque des revendications 1 à 9.

11. Procédé de fonctionnement d'un filtre actif récursif hybride (100, 200), comprenant un moyen amplificateur de puissance analogique (PA) dans une chaîne d'action, un premier moyen de traitement du signal numérique dans une boucle de réaction, un circuit de conversion analogique-numérique du côté entrée du premier moyen de traitement du signal numérique, et un circuit de conversion numérique-analogique du côté sortie du premier moyen de traitement du signal numérique, le procédé comprenant

l'amplification d'un signal d'entrée d'amplificateur par le moyen amplificateur de puissance analogique (PA) dans la chaîne d'action pour générer un signal de sortie (y(t)),

la génération d'un signal de réaction sur la base du signal de sortie (y(t)) et la combinaison du signal de réaction avec le signal d'entrée (x(t)) pour générer le signal d'entrée d'amplificateur par le premier moyen de traitement du signal numérique (DS) dans la boucle de réaction,

le signal de réaction étant généré dans le premier moyen de traitement du signal numérique (DS) par traitement du signal de sortie (y(t)) dans une pluralité de chaînes de réaction numériques, chaque chaîne de réaction numérique présentant une atténuation spécifique de la chaîne et un retard spécifique de la chaîne, et par combinaison des signaux traités issus de la pluralité de chaînes de réaction numériques,

le réglage de paramètres du premier moyen de traitement du signal numérique, les paramètres comportant l'atténuation spécifique de la chaîne et/ou le retard spécifique de la chaîne d'une ou plusieurs de la pluralité de chaînes de réaction numériques, et

la détection de caractéristiques de courant en boucle ouverte du filtre,

les paramètres du premier moyen de traitement du signal numérique étant réglés sur la base des caractéristiques de courant en boucle ouverte détectées du filtre,

**caractérisé en ce que** :

les caractéristiques en boucle ouverte du filtre comprennent une fonction de transfert en boucle ouverte pour éléments analogiques du filtre, les éléments analogiques comportant le moyen amplificateur de puissance, le circuit de conversion analogique-numérique et le circuit de conversion numérique-analogique.

12. Produit-programme informatique comprenant un code de programme informatique exécutable par ordinateur qui, quand le code de programme informatique est exécuté sur un ordinateur, est configuré pour conduire l'ordinateur à réaliser le procédé selon la revendication 11.

FIG 1

# FIG 2

200

## FIG 3

300

# FIG 4

400

## FIG 5

500

digital | analog

PA

x(t)

$\tau_{TX}$

a

$\tau_a$

y(t)

$\tau_d$

$\dfrac{1}{b}$

$\tau_{RX}$

$\tau_{d_2}$

$\dfrac{1}{b_2}$

$\tau_{d_3}$

$\dfrac{1}{b_3}$

$\tau_{d_i}$

$\dfrac{1}{b_i}$

DS

setting means

characterization means

# FIG 6

FIG 7

Measurements vs Simulations with 9 db gain and 1.55 us latency

FIG 8

transfer functions module

— closed loop with multi feedback
--- closed loop one feedback

② ①

magnitude [dB]

10
5
0
-5
-10
-15

8.466  8.468  8.47  8.472  8.474  8.476  8.478  8.48  8.482

frequency [Hz]

x 10⁸

=CL

—closed loop phase with multi feedback
--closed loop phase one feedback

phase [deg]

180
140
100
60
20
-20
-60
-100
-140
-180

② ①

8.466  8.468  8.47  8.472  8.474  8.476  8.478  8.48  8.482

frequency [Hz]

x 10⁸

=CL

x 10⁻⁶

— group delay multi feedback
--- group delay one feedback

delay [sec]

6
4
2
0
-2
-4
-6

② ①

8.466  8.468  8.47  8.472  8.474  8.476  8.478  8.48  8.482

frequency [Hz]

x 10⁸

EP 3 062 442 B1

FIG 9

FIG 10

FIG 11

Nyquist Diagram

Real Axis

Imaginary Axis

0 dB
-2 dB
-4 dB
-6 dB
-10 dB
-20 dB
2 dB
4 dB
6 dB
10 dB
20 dB

30

FIG 12

transfer functions module

— closed loop with multi feedback
-- closed loop one feedback

— closed loop phase with multi feedback
-- closed loop phase one feedback

— group delay multi feedback
-- group delay one feedback

=CL

=CL

EP 3 062 442 B1

# FIG 13

EP 3 062 442 B1

FIG 14

transfer functions module

magnitude [dB]

— closed loop with multi feedback
-- closed loop one feedback

frequency [Hz]
= CL

x 10⁸

phase [deg]

— closed loop phase with multi feedback
-- closed loop phase one feedback

frequency [Hz]
= CL

x 10⁸

delay [sec]

— group delay multi feedback
-- group delay one feedback

frequency [Hz]

x 10⁸

FIG 15

Nyquist Diagram

Real Axis

Imaginary Axis

FIG 16

transfer functions module

— closed loop with multi feedback
-- closed loop one feedback

①
②

=CL

— closed loop phase with multi feedback
-- closed loop phase one feedback

①
②

=CL

— group delay multi feedback
-- group delay one feedback

①
②

EP 3 062 442 B1

FIG 17

FIG 18

## FIG 19

Nyquist Diagram

EP 3 062 442 B1

FIG 20

## FIG 21

Nyquist Diagram

EP 3 062 442 B1

# FIG 22

FIG 23

EP 3 062 442 B1

**EP 3 062 442 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2001005402 A

- US 2012314736 A

### Non-patent literature cited in the description

- **G. GOTTARDO et al.** Novel Hybrid Recursive Active Filters in RF Transmitter Front-Ends. *published during the 2014 German Microwave Conference (GeMIC),* March 2014

- **A. P. LISITSKIY et al.** Digital Feedback Parameter Optimization. *published in Telecommunications and Radio Engineering,* August 1987, vol. 41/42 (8